(19) Europäisches Patentamt

European Patent Office

Office européen des brevets

(11) **EP 1 736 307 A1**

(12) **EUROPEAN PATENT APPLICATION**
published in accordance with Art. 158(3) EPC

(43) Date of publication:
**27.12.2006 Bulletin 2006/52**

(51) Int Cl.:
*B32B 9/00* (2006.01)   *B23B 27/14* (2006.01)
*B23B 51/00* (2006.01)   *B23C 5/16* (2006.01)
*C23C 16/32* (2006.01)   *C23C 28/04* (2006.01)

(21) Application number: **05727661.0**

(22) Date of filing: **29.03.2005**

(86) International application number:
**PCT/JP2005/005966**

(87) International publication number:
**WO 2005/092608 (06.10.2005 Gazette 2005/40)**

(84) Designated Contracting States:
**DE FR IT**

(30) Priority:   **29.03.2004   JP 2004096812
07.05.2004   JP 2004138863**

(71) Applicant: **KYOCERA CORPORATION
Kyoto-shi,
Kyoto 612-8501 (JP)**

(72) Inventors:
• **TANIBUCHI, Takahito,
c/o Kyocera Corporation
Satsumasendai-shi, Kagoshima 8950211 (JP)**
• **ISHII, Hiroki,
c/o Kyocera Corporation
Satsumasendai-shi, Kagoshima 8950211 (JP)**

(74) Representative: **HOFFMANN EITLE
Patent- und Rechtsanwälte
Arabellastrasse 4
81925 München (DE)**

(54) **SURFACE COATING MEMBER AND CUTTING TOOL**

(57)    The surface coated member comprises a substrate and a hard coating layer coated on the surface of the substrate. The hard coating layer comprises a lower layer composed of at least one layer and an upper layer composed of at least one layer and coated on the surface of the lower layer. When $F_U$ stands for a peeling load under which the upper layer starts to peel away from the surface of the lower layer and $F_L$ stands for a peeling load under which the lower layer starts to peel away from the surface of the substrate, the ratio ($F_L/F_U$) is 1.1 to 30. Thereby, it is possible to obtain a surface coated member that has excellent toughness and high fracture resistance, and that can be applied to a long life tool having excellent fracture resistance even under severe cutting conditions such as metal cutting, e.g., steel cutting and interrupted cutting of cast iron that bring a strong impact on a tool's cutting edge. It is also possible to maintain excellent fracture resistance and increase resistance to wear.

[FIG. 1]

**Description**

Technical Field

The present invention relates to a surface coated member whose surface is coated with a coating layer having excellent wear resistance as well as excellent fracture resistance and a cutting tool provided with the surface coated member, and in particular, to a cutting tool showing excellent cutting performance even during cutting that brings a large impact on a cutting edge.

Background Art

A surface coated member wherein the surface of a substrate is coated with a coating layer has been conventionally used for various applications. For example, a cutting tool wherein one or more coating layers such as titanium carbide (TiC) layer, titanium nitride (TiN) layer, titanium carbonitride (TiCN) layer, aluminum oxide ($Al_2O_3$) layer or the like are coated on the surface of a hard substrate such as cemented carbide, cermet and ceramics has been widely used in metal cutting.

Recently, as cutting becomes highly efficient, resistance to fracture and wear is required to be further improved. Particularly, such cutting as heavy interrupted cutting of metal that brings a large impact on a cutting edge has been on the increase. Under such severe cutting conditions, a conventional cutting tool does not allow a coating layer to endure a large impact and easily causes chipping and peeling of a coating layer. The problem is that such chipping and peeling of a coating layer cause unexpected tool failure such as a broken cutting edge or unusual wear, which makes it impossible for a tool to have a longer life.

In order to improve the characteristics of the above coating layer, Patent Document 1 discloses that a titanium carbonitride layer having vertically growing crystals is divided by a particulate titanium nitride layer, thereby inhibiting delamination and increasing fracture resistance of a tool.

Patent Document 2 describes that an aluminum oxide layer is coated on the surface of an $Al_2O_3$ ceramic substrate through CVD method and peeling occurred under a load of 5.9N (adhesive force 600g) in a scratch test. In addition, Patent Document 3 discloses that a coating layer composed of (Cr-Si-B)N is coated on the surface of the substrate composed of tool steel through ion plating method and the coating layer can attain a high scratch strength of 100N and be suitably applied to slide parts, cutting tools, molds or the like.

Patent Document 1: Japanese Unexamined Patent Publication No. 8-1408

Patent Document 2: Japanese Unexamined Patent Publication No. 5-169302
Patent Document 3: Japanese Unexamined Patent Publication No. 2002-212707

Disclosure of the Invention

Problem to be solved by the Invention

However, the structure of the coating layer described in Patent Document 1 has yet to make fracture resistance satisfactory. In particular, under recent severe cutting conditions such as heavy interrupted cutting that suddenly brings a large impact, chipping of a cutting edge still causes unusual wear and unexpected fracture, making tool life shorter. Moreover, when a coating layer has thin film thickness for the purpose of preventing chipping or peeling of the coating layer, the coating layer disappears earlier and wears away sooner, making it impossible for a tool to have a long life. Also, in steel cutting, resistance to fracture and wear has been required to be further improved.

The adhesive force of the coating layer in Patent Document 2 is insufficient in terms of adhesion to a substrate. Therefore, under cutting conditions that bring an impact, the coating layer peels early and wears away quickly. Furthermore, when a single-layer coating layer having strong adhesive force in Patent Document 3 is used for various applications, it suddenly receives a large impact in actual use and is easily broken. It is also necessary to take into consideration the oxidation of the coating layer surface and the compatibility with materials of a contactee to be contacted by a member. For this reason, the coating layer of Patent Document 3 cannot be applied as it is, and another coating layer needs to be coated as an upper layer. However, the problem of peeling in the interface between another coating layer and the lower coating layer having strong adhesive force remains unsolved.

The main advantage of the present invention is to provide a surface coated member that has excellent toughness and high fracture resistance and is suitably used especially for metal cutting such as steel cutting.

Another advantage of the present invention is to provide a surface coated member that can be applied to a long life tool having excellent fracture resistance even under severe cutting conditions such as interrupted cutting of cast iron that bring a strong impact on a tool's cutting edge.

The other advantage of the present invention is to provide a long life tool having excellent resistance to fracture and wear.

Means for solving the problem

A surface coated member of the present invention is based on the new finding that by providing a coating layer composed of at least two layers (a lower layer and an upper layer) on the surface of the substrate and optimizing adhesive force between the layers of the coating layer and between the coating layer and a substrate, it is possible to provide a surface coated member that has better toughness and fracture resistance without losing hardness necessary for practical use.

For example, even if a coating layer suddenly receives a large impact in cutting such as interrupted cutting which require fracture resistance, slight peeling between the layers of the coating layer or occurrence of cracks absorb the impact, thereby making it possible to reduce extensive peeling between the layers of a hard coating layer, and chipping, fracture and peeling of the entire coating layer.

The surface coated member according to the present invention comprises a substrate, a lower layer composed of at least one layer and coated on the surface of the substrate, and an upper layer composed of at least one layer and coated on the surface of the lower layer. When $F_U$ stands for a peeling load under which the upper layer starts to peel away from the surface of the lower layer and $F_L$ stands for a peeling load under which the lower layer starts to peel away from the surface of the substrate, the ratio ($F_L/F_U$) is 1.1 to 30.

It is desirable in order to improve wear resistance of a member that the peeling load $F_U$ is 10 to 75N and the peeling load $F_L$ is not less than 80N.
In addition, the interface roughness R in the interface between the upper and the lower layers that is figured out based on the method of arithmetical mean surface roughness (Ra) from irregular shape is desirably 0.5 to 3.0 $\mu$m in order to control the force of the lower side of the upper layer being pulled out and easily control the adhesive force of the upper layer.

Furthermore, desirably, the upper layer has a film thickness of 2.0 to 10.0 $\mu$m and the lower layer has a film thickness of 3.0 to 12.0 $\mu$m, in order to control the peeling load of each of the above layers and improve fracture resistance. By controlling film thickness in the above range, wear resistance becomes higher.

The combination of the upper layer having at least one aluminum oxide layer and the lower layer having at least one titanium carbonitride layer is desirable to provide very excellent resistance to wear and fracture.

It is desirable that the titanium carbonitride layer is composed of columnar titanium carbonitride crystals which have grown in a direction vertical to the surface of the substrate and that the mean crystal width of the columnar titanium carbonitride crystals on the aluminum oxide layer side is larger than the mean crystal width on the substrate side. In particular, it is desirable in order to control both adhesive force between the aluminum oxide layer and the titanium carbonitride layer and adhesive force between the substrate and the titanium carbonitride layer and to improve fracture resistance that the mean crystal width $w_1$ on the substrate side is 0.05 to 0.7 $\mu$m and that the ratio ($w_1/w_2$) of the mean crystal width $w_1$ on the substrate side to the mean crystal width $w_2$ of the columnar carbonitride crystals on the aluminum oxide layer side is not more than 0.7.

It is desirable in order to effectively stop the expansion of cracks that occur on the aluminum oxide layer side and further improve fracture resistance that the titanium carbonitride layer is composed at least of a titanium carbonitride upper layer coated on the aluminum oxide layer side and a titanium carbonitride lower layer coated on the substrate side and that the mean crystal width of the titanium carbonitride upper layer is larger than that of the titanium carbonitride lower layer. In this case, in terms of optimizing the wear resistance and fracture resistance of a member, the titanium carbonitride lower layer may have a film thickness $t_1$ of 1.0 to 10.0 $\mu$m, the titanium carbonitride upper layer may have a film thickness $t_2$ of 1.0 to 5.0 $\mu$m, and the relation of $1< t_1/ t_2 \leq 5$ may be satisfied.

When the titanium carbonitride lower layer is viewed from the surface, the titanium carbonitride lower layer may be composed of the aggregate of acicular titanium carbonitride particles, and the acicular titanium carbonitride particles may respectively grow in a random direction on the surface of the titanium carbonitride lower layer. This enhances so-called crack deflection effect which means that cracks expand not straight but zigzag, prevents cracks from expanding at a stretch and improves fracture resistance.

In order to enhance the effect of deflecting cracks that have occurred in the coating layer and preventing cracks from expanding, increase the fracture toughness of the coating layer and improve fracture resistance, it is desirable that the acicular titanium carbonitride particles have an average aspect ratio of not less than 2 when observed from the surface direction of the titanium carbonitride lower layer.

It is also desirable in terms of increasing the strength of the titanium carbonitride layer itself and improving the wear resistance of the titanium carbonitride layer that the acicular titanium carbonitride particles have an average long axis length of not more than 1 $\mu$m when observed from the surface direction of the titanium carbonitride lower layer.

In the surface coated member of the present invention, at least one of a surface layer coated on the uppermost surface of the upper layer, a middle layer coated on the bottommost surface of the upper layer and a base layer coated on the surface of the substrate in the lower layer may be a coating layer composed of one or more layers selected from the group consisting of TiN layer, TiC layer, TiCNO layer, TiCO layer and TiNO layer.

By coating the Ti-based coating layer as above as a base layer on the titanium carbonitride lower layer, it is possible to achieve the effect of inhibiting the diffusion of substrate components and to easily control the crystal structure of the titanium carbonitride layer. In addition, by forming the Ti-based coating layer as above as a middle layer between the titanium carbonitride layer and the aluminum oxide layer, it becomes easy to adjust the adhesive force between the titanium carbonitride layer and the aluminum oxide layer. Moreover, the crystal structure of the aluminum oxide layer can be optimized and the peeling load of the aluminum oxide layer can be easily controlled. By coating the Ti-based coating layer as above as a surface layer on the surface of the aluminum oxide layer, it becomes possible to adjust the tribology property and appearance of the surface of the coating layer.

Furthermore, at least one of the titanium carbonitride layer and the aluminum oxide layer may be composed of two or more layers, and a coating layer selected from the group consisting of TiN layer, TiC layer, TiCNO layer, TiCO layer and TiNO layer (hereinafter, referred to as another Ti-based interlayer coating layer) may be formed between the two or more layers. This has the effect of further increasing the toughness of the member. The aluminum oxide layer desirably has $\alpha$ (alpha)-type crystal structure to keep structurally stable and maintain excellent wear resistance even at high temperature.

The cutting tool of the present invention performs cutting, putting on a workpiece material a cutting edge that is formed on the cross ridge portion of a rake face and a flank face. The cutting edge is composed of the above-mentioned surface coated member. In particular, the cutting tool of the present invention comprises a substrate, a titanium carbonitride layer coated on the surface of the substrate and an aluminum oxide layer coated on the surface of the titanium carbonitride layer. When $F_U$ stands for a peeling load under which the aluminum oxide layer starts to peel away from the surface of the titanium carbonitride layer and $F_L$ stands for a peeling load under which the titanium carbonitride layer starts to peel away from the surface of the substrate, the peeling load $F_U$ under which the aluminum oxide layer starts to peel may be 10 to 75N, the peeling load $F_L$ under which the titanium carbonitride layer starts to peel may be not less than 80N, and the ratio ($F_L/F_U$) may be 1.1 to 30.

The other surface coated member of the present invention is based on the new finding that by observing depression that are formed when so-called Calotest is conducted on a surface coated member wherein a hard coating layer including at least a titanium carbonitride layer and an aluminum oxide layer coated as its upper layer is provided on the substrate surface, evaluation can be made on partial distribution of wear resistance and fracture resistance in the hard coating layer.

Observing the depression, the substrate is exposed at the center of the depression. If the density of cracks in the titanium carbonitride layer which are observed around the substrate, that is, average crack spacing is most appropriate, residual stress occurring between the titanium carbonitride layer and the aluminum oxide layer as an upper layer is relieved. For example, even if a hard coating layer suddenly receives a large impact during interrupted cutting, the impact can be absorbed without chipping and fracture in the hard coating layer caused by another large crack. The presence of a lower structure of the titanium carbonitride layer where cracks are rarely produced prevents the expansion of cracks produced in an upper structure. Therefore, the titanium carbonitride layer or the entire hard coating layer undergoes neither chipping nor peeling. As a result, it is possible to prevent the chipping and peeling of the entire hard coating layer and improve the wear resistance of the entire hard coating layer.

The surface coated member according to the present invention comprises a substrate and a hard coating layer coated on the surface of the substrate. The hard coating layer includes at least one titanium carbonitride layer and an aluminum oxide layer coated as an upper layer of the titanium carbonitride layer. Calotest is conducted by putting a hard ball on the surface of the surface coated member and rotating the hard ball on its own axis. The contact point of the hard ball in the surface coated member is partially worn down and a depression having a spherical surface is formed in the hard coating layer so as to expose the substrate to the center. According to the surface coated member of the present invention, the titanium carbonitride layer which is observed at the periphery of the substrate exposed at the center of the depression has a lower structure and an upper structure. The lower structure has no or few cracks. The upper structure is observed at the periphery of the lower structure and has higher density of cracks than the lower structure.

Desirably, the titanium carbonitride layer which is seen at the periphery of the substrate exposed at the center of the depression when observing the depression in the Calotest is composed of a multilayer including a lower titanium carbonitride layer and an upper titanium carbonitride layer. The lower titanium carbonitride layer is observed around the exposed substrate in the center of the depression and has no or few cracks. The upper titanium carbonitride layer is observed around the lower titanium carbonitride layer and has higher density of cracks than the lower titanium carbonitride layer. This makes it possible to enhance the effect of preventing cracks produced in the upper part of the titanium carbonitride layer from expanding continuously and reaching the bottom part and to ensure that chipping and fracture are inhibited.

It is desirable that the lower titanium carbonitride layer has a film thickness $t_3$ of $1 \, \mu m \leq t_3 \leq 10 \, \mu m$, the upper titanium carbonitride layer has a film thickness $t_4$ of $0.5 \, \mu m \leq t_4 \leq 5 \, \mu m$, and the relation of $1 < t_3/ t_4 \leq 5$ is satisfied. Thereby, it is possible not only to increase adhesion between the titanium carbonitride layer and the aluminum oxide layer and inhibit the crack expansion of the titanium carbonitride layer itself, but also to increase the impact resistance of the entire hard coating layer, prevent chipping and fracture in a tool as a whole and maintain high wear resistance.

It is desirable that the titanium carbonitride layer is composed of columnar titanium carbonitride particles which grow vertically to the surface of the substrate and that the mean crystal width of the titanium carbonitride particles constituting the upper titanium carbonitride layer is larger than that of the titanium carbonitride particles constituting the lower titanium carbonitride layer. This makes it possible to prevent cracks produced in the upper titanium carbonitride layer from expanding throughout the lower titanium carbonitride layer and reduce residual stress between the aluminum oxide layer and the titanium carbonitride layer to minimize the occurrence of cracks and control adhesive force between the both. Thereby, it is possible to increase resistance to wear and peeling in the hard coating layer and achieve the most appropriate resistance to wear and fracture in a tool as a whole.

In this case, desirably, the upper titanium carbonitride layer has a mean crystal width $w_4$ of 0.2 to 1.5 $\mu$m and the ratio ($w_3/w_4$) of the mean crystal width $w_3$ in the lower titanium carbonitride layer to the mean crystal width $w_4$ of the upper titanium carbonitride layer is not more than 0.7. Thereby, it is possible to increase the resistance to fracture and chipping of titanium carbonitride crystals themselves, control adhesive force to the aluminum oxide layer and enhance the resistance to wear and fracture in the hard coating layer as a whole.

Provided a general formula: Ti ($C_{1-m}N_m$) represents the lower titanium carbonitride layer and the upper titanium carbonitride layer, it is desirable that the lower titanium carbonitride layer meets the condition of m=0.55 to 0.80 and the upper titanium carbonitride layer meets the condition of m=0.40 to 0.55. This makes it possible to prevent cracks produced in the titanium carbonitride layer on the upper part of the substrate from expanding throughout the lower titanium carbonitride layer, increase resistance to chipping and fracture in the hard coating layer and maintain high wear resistance. The surface coated cutting tool of the present invention is provided with the above-mentioned surface coated member.

Effect of the Invention

According to the surface coated member according to the present invention, a coating layer is composed of at least two layers and the adhesive force between the layers and between the coating layer and a substrate is optimized. Thereby, it is possible to increase toughness while keeping hardness in a practical range and enhance fracture resistance while having practical wear resistance. For instance, when applied to a cutting tool, even in an operation where fracture resistance is required, slight peeling between the layers or occurrence of cracks absorb an impact, thus making it possible to prevent large peeling and the chipping of the entire coating layer. Moreover, even if peeling occurs between the layers of the coating layer, the remaining lower layer has not only some parts where mean crystal width is very small and resistance to wear is high, but also strong adhesive force to the substrate. Therefore, it is possible to prevent the progress of wear in the entire coating layer and improve wear resistance. In addition, by optimizing the peeling loads $F_U$ and $F_L$, the coating layer shows high wear resistance without peeling, even in such operations as continuous cutting that requires wear resistance.

According to the other surface coated member according to the present invention, the titanium carbonitride layer which is observed at the periphery of the exposed substrate in the center of the depression in the Calotest has a lower structure and an upper structure. The lower structure has no or few cracks. The upper structure is observed at the periphery of the lower structure and has higher density of cracks than the lower structure. In other words, cracks are produced preferentially in the upper structure, thereby making it possible to relieve residual stress generated between the titanium carbonitride layer and the upper aluminum oxide layer.

For that reason, fracture resistance can be increased as a cutting tool. More specifically, even if a hard coating layer suddenly receives a large impact under severe cutting conditions, continuous cutting conditions or combined cutting conditions of interrupted cutting and continuous cutting, it is possible to absorb the impact mainly in the upper structure without chipping and fracture in the hard coating layer due to occurrence of another large crack. Since the presence of the lower structure of the titanium carbonitride layer where cracks are hardly produced prevents the expansion of cracks produced in the upper structure, the titanium carbonitride layer undergoes neither chipping nor peeling. Consequently, chipping and peeling in the entire hard coating layer can be prevented while wear resistance in the entire hard coating layer is maintained. Thereby, it is possible to obtain a cutting tool having excellent resistance to chipping and fracture.

The cutting tool provided with the above surface coated member in the present invention has excellent resistance to fracture, chipping and wear, even under severe cutting conditions that bring a strong impact on a tool cutting edge such as heavy interrupted cutting of metals including gray iron (FC), ductile cast iron (FCD) and other cast iron having very hard graphite particles dispersed as well as steel cutting, continuous cutting conditions or combined cutting conditions of interrupted cutting and continuous cutting. And the tool can have a longer life.

The surface coated member of the present invention can be not only applied to cutting tools but also used for various applications including slide parts, wear resistant parts of molds, excavating tools, such tools as blades and impact resistant parts. Even in these applications, it has excellent mechanical reliability.

Preferred Embodiments for Practicing the Invention

(First embodiment)

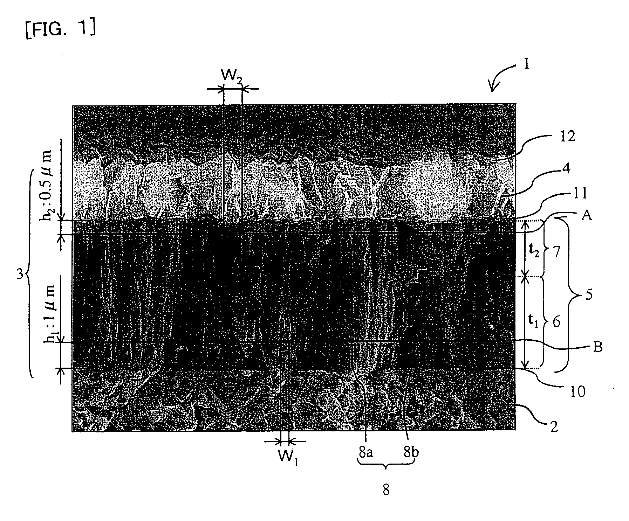

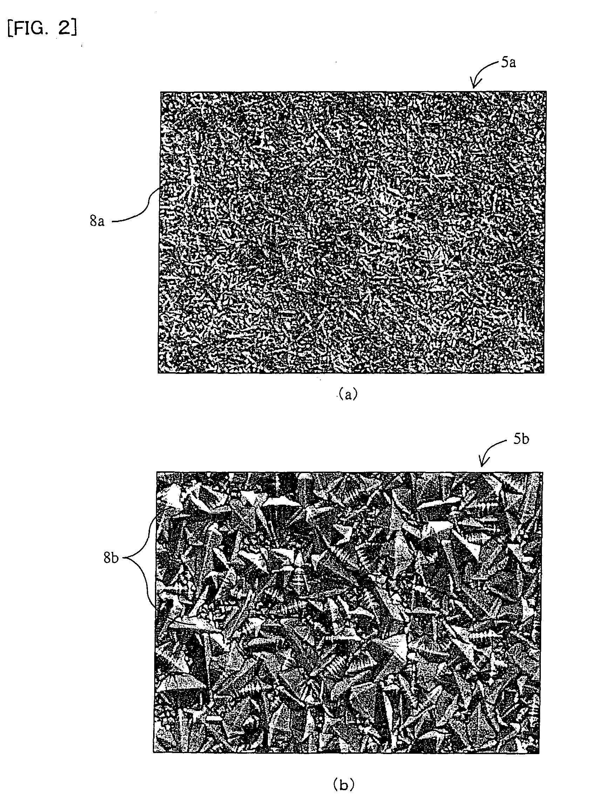

The first embodiment of a surface coated cutting tool which is a preferred example of the surface coated member of the present invention will be described with reference to Fig. 1 and Fig. 2. Fig. 1 is a photograph of the fracture surface of a coating layer taken with a scanning electron microscope (SEM). Fig. 2 is a photograph taken with a scanning electron microscope (SEM), showing the surface where the titanium carbonitride layer in a coating layer is coated so as to have a certain thickness.

According to Fig. 1, a surface coated cutting tool (hereinafter, referred to simply as tool) 1 comprises a substrate 2 (cemented carbide in Fig. 1) and a hard coating layer 3 having at least two layers that is coated on the surface of the substrate 2. The substrate 2 is made of, for example, cemented carbide or cermet wherein hard phases are bound with binder phases consisting of an iron group metal such as cobalt (Co) and/or nickel (Ni). A hard phase here is composed of, for example, tungsten carbide (WC), titanium carbide (TiC) or titanium carbonitride (TiCN) and, if desired, at least one selected from the group consisting of carbide, nitride and carbonitride of metals of the groups 4a, 5a and 6a of the periodic table. The substrate 2 can be made of a silicon nitride ($Si_3N_4$) or aluminum oxide ($Al_2O_3$) ceramic sintered body, hard materials such as a superhard sintered body mainly composed of cubic boron nitride (cBN) or diamond, or such metals as carbon steel, high-speed steel and alloy steel.

In the tool 1, the hard coating layer 3 is composed of a lower layer 5 composed of at least one layer and coated on the substrate side, and an upper layer 4 composed of at least one layer and coated on the surface side of the lower layer 5. When $F_U$ stands for a peeling load under which the lower surface of the upper layer 4 starts to peel away from the upper surface of the lower layer 5, and $F_L$ stands for a peeling load under which the lower surface of the lower layer 5 starts to peel away from the surface of the substrate 2, the ratio ($F_L/F_U$) is 1.1 to 30.

Thereby, in operations that require fracture resistance, wear resistance of the upper layer 4 which has no problem from a practical viewpoint is ensured, and slight peeling and occurrence of cracks in the upper layer 4 absorb an impact, which makes it possible to prevent large peeling or chipping of the entire coating layer 3. Furthermore, even if the upper layer 4 peels, strong adhesive force between the remaining lower layer 5 and the substrate contributes to prevention of wear and fracture, allowing the entire coating layer 3 to have high fracture resistance.

The peeling load of the coating layer 3 can be found out, for example, by measuring adhesive force in the scratch test of the coating layer 3. Specifically, in the above scratch test, measurement is made by scratching the surface of the coating layer 3 of the surface coated cutting tool 1 with a diamond indenter under the following conditions.
(Indenter)
Spherical diamond indenter (diamond stylus)
Radius: 0.2 mm
Apex angle: 120-
(Test conditions)
Scratch speed: 0.17 mm/second
Loading rate: 100N/minute (continuous loading)
(Note that the initial load is adjusted according to a peeling load.)
Scratch length: 5 mm
Evaluation: The above scratch track is observed with a microscope.
In this regard, either of the following locations (1) or (2) is specified; (1) the location where the upper layer peels away from the surface of the lower layer under it, that is, the upper layer starts to peel and the lower layer starts to be exposed; (2) the location where the upper layer breaks down under the load of a diamond indenter exceeding the strength of the upper layer itself and the lower layer under it is exposed, that is, the upper layer starts to break down and the lower layer starts to be exposed. In other words, the boundary point in the scratch track between the area where the upper layer is exposed and the area where the lower layer different from the upper layer is exposed is specified and the load at this point is figured out. Thereby, it is possible to find out a peeling load ($F_U$) under which the upper layer starts to peel away from the surface of the lower layer.

When it is difficult to specify the point only by observing the structure, X-ray electron probe micro-analysis or X-ray photoelectron spectroscopy can be used to identify the elemental components exposed to the surface and specify the peeling load.

In the above scratch test, it is desirable in terms of accurate measurement that measurement is made on the flat surface of the surface coated member. For example, in a cutting tool having a principal surface as rake face and a side surface as flank face, like a throw-away tip being substantially flat plate, a peeling load is measured on the flank face which does not form a breaker or a picture pattern. If the flank face has a shape that makes it difficult to make measurement, a measured value in a measurable part can be substituted. In particular, it is desirable that the substitute part is in a state of fired surface where the surface of the substrate is not polished and that it is the part where this surface is coated with a coating layer. However, even if the surface of the substrate is polished, the present invention does not lose effect.

According to the present invention, among many layers in a coating layer, the lower layer 5 represents a coating layer which starts to peel away from the substrate 2. Basically, in many cases, the lower layer 5 stands for a first coating layer. However, for example, when the first coating layer directly on the substrate 2 peels together with a second coating layer that is coated on the first coating layer, the first and second coating layers are viewed as the lower layer 5. Similarly, when three or more layers peel away from the substrate 2 at the same time, a multilayer peeling away from the substrate 2 are viewed as the lower layer 5, and the peeling load of the lower layer 5 is $F_L$.

As for the upper layer 4, the peeling load of the first upper layer which is directly on the lower layer 5, that is, which is located at the bottom layer of the upper layer 4, basically stands for the peeling load $F_U$ of the upper layer 4. In this case as well, when the first upper coating layer peels together with a second upper coating layer in the upper layer 4, the peeling load of the second upper coating layer is the peeling load $F_U$ of the upper layer 4. Similarly, when a third upper layer peels together with the first upper layer, the peeling load of the third upper layer which peels together with the first upper layer is the peeling load $F_U$ of the upper layer 4. In this manner, when a multilayer peel together with the first upper layer in the upper layer 4, the peeling load of the uppermost layer of the multilayer which peel together with the first upper layer is the peeling load $F_U$ of the upper layer 4. In addition, in the structure of the upper layer, in some cases, before the first upper coating layer peels, the second and higher upper coating layers peel under low load and then the first upper layer is exposed. However, in the present invention, the peeling load of the second and higher upper coating layers like this case is not the peeling load $F_U$ of the upper layer. In short, a coating layer having the largest peeling load among coating layers in the hard coating layer 3 is the lower layer 5 and the peeling load of the lower layer 5 is the peeling load $F_L$. A coating layer having the second largest peeling load among coating layers in the hard coating layer 3 is the upper layer 4 and the peeling load of the upper layer 4 is the peeling load $F_U$.

According to the structure of Fig. 1, it is highly probable that the upper layer 4 is an aluminum oxide layer and that the lower layer 5 is a titanium carbonitride layer. For this reason, in the following description based on Fig. 1, the upper layer 4 is viewed as an aluminum oxide layer 4 and the lower layer 5 is viewed as a titanium carbonitride layer 5. The tool 1 having such structure has practical structure in terms of resistance to wear and fracture.

In order for the coating layer 3 to have a highly wear resistant structure without peeling during operations that require wear resistance, the above ratio ($F_L/F_U$) is especially desirably 1.2 to 10. Furthermore, in order to ensure practical wear resistance as a cutting tool and improve fracture resistance, the above ratio ($F_L/F_U$) is more desirably 1.5 to 5.

That is, in the structure of Fig. 1, by controlling the ratio of the peeling load $F_L$ under which the titanium carbonitride layer 5 peels away from the substrate 2 to the peeling load $F_U$ of the aluminum oxide layer 4 within the above specific range, it is possible to optimize fracture resistance, more preferably, wear resistance in the coating layer 3 and further preferably to improve the fracture resistance of a cutting tool while ensuring practical wear resistance as a cutting tool.

Moreover, according to the structure of Fig. 1, it is desirable in terms of improving the fracture resistance of a member that the peeling load $F_U$ of the aluminum oxide layer 4 is 10 to 75N and the peeling load $F_L$ of the titanium carbonitride layer 5 is not less than 80N. In particular, it is more desirable in terms of increasing the wear resistance of a member that the peeling load $F_U$ of the aluminum oxide layer 4 is 20 to 60N and the peeling load $F_L$ of the titanium carbonitride layer 5 is not less than 100N. It is further desirable in terms of ensuring practical wear resistance as a cutting tool and improving fracture resistance that the peeling load $F_U$ of the aluminum oxide layer 4 is 30 to 45N and the peeling load $F_L$ of the titanium carbonitride layer 5 is not less than 110N.

In observing the structure of the coating layer 3, it is desirable in terms of surely controlling the adhesive force of the coating layer 3 that interface roughness R in the lower surface (interface) of the aluminum oxide layer 4 (upper layer) where peeling or breakdown start between the layers of the coating layer is 0.5 to 3 $\mu$m.

The interface roughness R can be found out from the irregular shape of the interface, based on the method of arithmetical mean surface roughness (Ra). Specifically, surface roughness R in the present invention is defined as a value which is figured out based on the method specified in JIS B 0601-2001 (IS04287-1997) to calculate arithmetical mean surface roughness (Ra), considering the irregular shape traced on the lower surface of the upper layer 4 as surface shape.

In order to control the peeling loads of the upper layer 4 and the lower layer 5 and increase fracture resistance, it is desirable that the film thickness $t_U$ of the upper layer 4 is 2.0 to 10.0 $\mu$m and the film thickness $t_L$ of the lower layer 5 is 3.0 to 12.0 $\mu$m. By setting film thickness to the above-mentioned, the effect of improving the wear resistance of the tool 1 is obtained.

In Fig. 1, when viewed from a cross-sectional direction vertical to the film surface, the titanium carbonitride layer 5 is composed of columnar titanium carbonitride crystals which grow vertically to the surface of the substrate 2. To control peeling load, it is desirable that the mean crystal width of the aluminum oxide layer 4 side is larger than that of the substrate 2 side in the columnar titanium carbonitride crystals.

To adjust both the adhesive force between the upper layer 4 and the lower layer 5 and the adhesive force between the substrate 2 and the lower layer 5 and control peeling load to prevent chipping, it is desirable that the mean crystal width $w_1$ on the substrate 2 side is 0.05 to 0.7 $\mu$m and the ratio ($w_1/w_2$) of the mean crystal width $w_1$ on the substrate 2 side to the mean crystal width $w_2$ of the columnar titanium carbonitride crystals on the aluminum oxide layer 4 side is not more than 0.7.

The above mean crystal width is specifically measured under the following condition: $w_1$ is considered as the mean crystal width of the titanium carbonitride layer 5 at a position (height $h_1$ and line B where a crystal width w cuts across a small area by nucleation) 1 $\mu$m away from the interface between the titanium carbonitride layer 5 and the substrate 2 toward a vertical direction to the interface; and $w_2$ is considered as the mean crystal width at a position ($h_2$ and line A) 0.5 $\mu$m away from the interface between the titanium carbonitride layer 5 and the aluminum oxide layer 4 vertically toward the substrate 2.

In order to prevent films from peeling and maintain wear resistance, it is desirable that the total film thickness of the titanium carbonitride layer 5 (in Fig. 1, a titanium carbonitride lower layer 6 and a titanium carbonitride upper layer 7) is 5 to 15 $\mu$m when the titanium carbonitride layer 5 has a multilayer structure. Furthermore, in order to keep wear resistance, especially wear resistance to cast iron, and adhesion resistance and to increase fracture resistance, it is desirable that the film thickness of the aluminum oxide layer 4 is 2 to 8 $\mu$m.

Desirably, the titanium carbonitride layer 5 is composed of two or more layers including the titanium carbonitride lower layer 6 which is located at the substrate 2 side and has a small mean crystal width and the titanium carbonitride upper layer 7 which is located at the aluminum oxide layer 4 side and has a large mean crystal width, in order to effectively stop the expansion of cracks occurring on the aluminum oxide layer 4 side and to further increase fracture resistance.

In this case, from the viewpoint of optimizing wear resistance and fracture resistance in the tool 1, it is desirable that the film thickness $t_1$ of the titanium carbonitride lower layer 6 is 1 to 10 $\mu$m, the film thickness $t_2$ of the titanium carbonitride upper layer 7 is 1 to 5 $\mu$m and the relation of $1 < t_1/t_2 \leq 5$ is satisfied.

Desirably, when viewed from the surface direction, the titanium carbonitride lower layer 6 is composed of the aggregate of acicular titanium carbonitride particles (hereinafter, referred to as fine titanium carbonitride particles 8a) and the fine titanium carbonitride particles 8a respectively grow in a random direction in relation to the surface direction of the titanium carbonitride lower layer 6. This makes it possible to increase the effect of deflecting cracks in the titanium carbonitride lower layer 6 and prevent cracks from expanding in the depth direction of the titanium carbonitride layer 5. And this is desirable in terms of improving fracture resistance without causing chipping and layer peeling in the titanium carbonitride layer 5.

It is desirable from the viewpoint of preventing cracks form expanding and increasing fracture resistance that the fine titanium carbonitride particles 8a have an average aspect ratio of not less than 2 when the titanium carbonitride layer 5 is observed from the surface direction. Particularly, in order to increase the effect of facilitating crack deflection and increase fracture resistance more effectively, the average aspect ratio is more desirably not less than 3 and much more desirably not less than 5.

The fine titanium carbonitride particles 8a of the titanium carbonitride layer 5 grow in a direction vertical to the film surface (that is, the substrate surface). It is desirable in order to increase impact absorption that the fine titanium carbonitride particles 8a are columnar crystals having an average aspect ratio of not less than 3, preferably not less than 5 when observed form a cross-sectional direction. In particular, it is desirable in order to increase the hardness of the titanium carbonitride layer 5 itself and improve wear resistance that the average aspect ratio is not less than 8 and preferably not less than 10.

Taking into consideration the observations in cross-sectional and surface directions, the fine titanium carbonitride particles 8a in the titanium carbonitride layer 5 are projected to be plate-like crystals. The aspect ratio of particles (the above fine titanium carbonitride particles 8a) can be estimated by calculating the maximum value of the length ratio of [the length of a short axis orthogonal to a long axis] to [that of the long axis] in each particle and averaging the aspect ratio of each titanium carbonitride particle existing in one field of view. In observing the cross-sectional structure, the coating layer 3 may be composed of mixed crystals containing not more than 30 area % of particulate titanium carbonitride crystals.

When observing the structure of the titanium carbonitride particles 8 in a surface direction and measuring the average aspect ratio, if the uppermost surface is a titanium carbonitride layer (hereinafter, referred to as fine titanium carbonitride layer 5a) composed of the above plate-like titanium carbonitride particles 8a, as shown in Fig. 2 (a), the surface can be observed with a SEM. On the other hand, if there is another layer on the surface of the fine titanium carbonitride layer 5a, it is effective to perform polishing so that only a certain part of the coating layer 3 can remain and subsequently to observe the polished part, for example, at a high resolution image (x5000 to x200000) with a transmission electron microscope (TEM). Even if the coating layer 3 is a multilayer coating layer wherein other hard layers are coated on the upper surface of the fine titanium carbonitride layer 5a, this method makes it possible to ensure that the structure of the fine titanium carbonitride particles 8a can be checked from a surface direction.

In addition, when observing the structure in a cross-sectional direction and measuring the average aspect ratio, it is possible to conduct measurement by fracturing or grinding the tool 1 in a direction vertical to the surface of the substrate 2 and observing the fracture surface or the grinding surface, for example, at a high resolution image (x3000 to x50000) with a scanning electron microscope (SEM).

Fig. 2 is a scanning electron micrograph of the surface where a fine titanium carbonitride layer is coated. As shown in Fig. 2 (a), it is desirable that the fine titanium carbonitride particles 8a have an average long axis length of not more than 1 μm when the fine titanium carbonitride particles 8a of the fine titanium carbonitride layer 5a is observed from the surface, because it is possible to achieve the effect of deflecting cracks that have occurred in the fine titanium carbonitride layer 5a and preventing cracks from expanding and to improve the strength of the coating layer 3 itself and increase fracture resistance.

Unlike the structure of the fine titanium carbonitride layer 5a, for example, as shown in Fig. 2 (b), in the titanium carbonitride upper layer 7, titanium carbonitride particles 8b desirably have an average length of not less than 1 μm so as to control adhesive force to the aluminum oxide layer 4 and the peeling load $F_U$ of the upper layer. In this case, the aspect ratio of the titanium carbonitride particles 8b may be not more than 2 but desirably 2 to 5 in order to improve adhesive force to the aluminum oxide layer 4.

The above aluminum oxide layer desirably has α(alpha)-type crystal structure so as to keep structurally stable and maintain excellent wear resistance even at high temperature. Conventionally, aluminum oxide having α(alpha)-type crystal structure has excellent wear resistance, but the problem is that large-sized nucleus produced during nucleation narrow the contact area with the titanium carbonitride layer 5 and weaken adhesive force, thereby easily causing film peeling. However, since the above structural adjustment makes it possible to control the adhesive force between the aluminum oxide layer 4 and the lower layer 5 that is a titanium carbonitride layer within a specific range, even the aluminum oxide layer 4 having α(alpha)-type crystal structure can obtain enough adhesive force. Therefore, it is possible to obtain adhesive force, without being deteriorated, in the aluminum oxide layer 4 composed of aluminum oxide having α(alpha)-type crystal structure and excellent wear resistance, thereby obtaining the tool 1 which has a longer tool life. It is also possible to adjust the adhesive force of the aluminum oxide layer 4 by letting some part of aluminum oxide crystals have κ(kappa)-type crystal structure, not α(alpha)-type crystal structure, that is, by making the crystal structure of the aluminum oxide layer 4 the mixed crystals of α(alpha)-type crystal structure and κ(kappa)-type crystal structure.

Moreover, at least one of a surface layer coated on the uppermost surface of the upper layer, a middle layer coated on the bottommost surface of the upper layer and a base layer coated on the surface of the substrate in the lower layer are preferably a coating layer composed of one or more layers (hereinafter, referred to as another Ti-based coating layer) selected from the group consisting of TiN layer, TiC layer, TiCNO layer, TiCO layer and TiNO layer. Specifically, as shown in Fig. 1, a base layer 10 composed of TiN having 0.1 to 2 μm thick is formed between the substrate 2 and the titanium carbonitride layer 5 to improve the adhesive force of the titanium carbonitride layer 5 and prevent wear resistance from deteriorating due to diffusion of substrate components. The base layer 10 peels together with the titanium carbonitride layer 5 since it is thin and has strong adhesive force to the titanium carbonitride layer 5. In some cases, carbon diffuses from the substrate 2 or the titanium carbonitride layer 5 and then TiN layer that is a base layer is absorbed into the titanium carbonitride layer 5 and disappears. Therefore, when the scratch strength of the titanium carbonitride layer 5 of the tool 1 in the structure of Fig. 1 is measured, in many cases, the titanium carbonitride layer 5 and the base layer 10 start to peel together. In this case, the substrate 2 comes to be exposed at the time when the titanium carbonitride layer 5 starts to peel.

When the aluminum oxide layer 4 has α(alpha)-type crystal structure, it is desirable in order to allow α(alpha)-type crystal structure to grow stably that a middle layer 11 having a thickness of not more than 1 μm, which is any of TiCO layer, TiNO layer and TiCNO layer, is formed between the titanium carbonitride layer 5 and the aluminum oxide layer 4. Especially, the thickness of not more than 0.5 μm is desirable to easily control the adhesive force of the aluminum oxide layer 4 (coating layer of the upper layer).

Desirably, when a surface layer 12 composed of TiN is coated on the upper layer of the aluminum oxide layer 4, that is, the surface of the hard coating layer 3, a tool is colored gold. This makes it easy to judge whether the tool is used or not from the wear of the surface layer 12 when using the tool 1, and also makes it possible to easily check the progress of wear. Furthermore, the surface layer 12 is not limited to TiN layer and, in some cases, DLC (diamond-like carbon) layer or CrN layer is coated to enhance tribology property. The thickness of TiN layer constituting the surface layer 12 is desirably not more than 1 μm. In order to make it easy to visually check the status of use, it is also desirable that the peel strength of the surface layer 12 is smaller than that of the aluminum oxide layer 4.

As above, when another Ti-based coating layer as middle layer is formed between the titanium carbonitride layer and the aluminum oxide layer, the middle layer peels together with the aluminum oxide layer. Moreover, the TiN layer coated as surface layer on the upper surface of the aluminum oxide layer peels under lower load than the peeling load of the aluminum oxide layer. In this case, the peeling load $F_U$ of the upper layer 4 is the peeling load of the aluminum oxide layer.

At least one of the titanium carbonitride layer and the aluminum oxide layer may be composed of two or more layers, and a layer selected from the group consisting of TiN layer, TiC layer, TiCNO layer, TiCO layer and TiNO layer may be formed between the respective layers of the two or more layers constituting the titanium carbonitride layer and/or the aluminum oxide layer. Such a structure enables a member to have much better fracture resistance.

(Manufacturing method)

The method for manufacturing a surface coated cutting tool according to this embodiment will be next described. First, metal powder, carbon powder and the like are properly added to and mixed with inorganic powder such as metal carbide, nitride, carbonitride and oxide that can form the aforementioned hard alloy by sintering, and then molded into a predetermined tool shape through a well-known method such as press molding, slip casting, extrusion molding and cold isostatic pressing. Subsequently, through sintering in vacuum or in non-oxidation atmosphere, the substrate 2 composed of the aforementioned hard alloy is prepared. If desired, polishing is performed on the surface of the substrate 2 and honing is performed on the cutting edge part.

Regarding the surface roughness of the substrate 2, from the viewpoint of controlling the adhesive force of the coating layer, the particle size of raw material powder, the molding method, the sintering method and the processing method are controlled so that the arithmetical mean surface roughness (Ra) on the rake face can be 0.1 to 1.5 $\mu$m and the arithmetical mean surface roughness (Ra) on the flank face can be 0.5 to 3.0 $\mu$m.

Then, the coating layer 3 is coated on the surface, for example, through chemical vapor deposition (CVD) method. First, setting the conditions inside a reactor (chamber) to 800 to 1000°C and 10 to 30 kPa, a mixed gas composed of 0.1 to 10 vol. % of titanium chloride ($TiCl_4$) gas, 0 to 60 vol. % of nitrogen ($N_2$) gas and hydrogen ($H_2$) gas for the rest as reactive gas composition is adjusted and introduced into the reactor to form TiN layer as base layer.

Next, for example, another mixed gas composed of 0.1 to 10 vol. % of titanium chloride ($TiCl_4$) gas, 0 to 60 vol. % of nitrogen ($N_2$) gas, 0 to 0.1 vol. % of methane ($CH_4$) gas, 0.1 to 0.4 vol. % of acetonitrile ($CH_3CN$) gas and hydrogen ($H_2$) gas for the rest as reactive gas composition is prepared and introduced into a reactor, and the titanium carbonitride layer 5 is coated at a film coating temperature of 780 to 880°C and 5 to 25 kPa.

Regarding the above film coating conditions, by adjusting the percentage of acetonitrile gas in the reactive gas to 0.1 to 0.4 vol. %, it is possible to surely grow the structure of the fine titanium carbonitride particles 8a in the fine titanium carbonitride layer 5a in the aforementioned range. As for the above film coating temperature, a temperature of 780 to 880°C is desirable to form the fine titanium carbonitride layer 5a composed of the fine titanium carbonitride particles 8a which are columnar in cross-sectional observation and acicular in surface observation.

In this embodiment, the percentage of acetonitrile ($CH_3CN$) gas in the reactive gas used in the second stage of coating the titanium carbonitride layer (when the titanium carbonitride upper layer is coated) is made larger than that of $CH_3CN$ in the reactive gas used in the first stage of coating the titanium carbonitride layer (when the titanium carbonitride lower layer is coated). Thereby, the mean crystal width of titanium carbonitride particles in the titanium carbonitride upper layer is made larger than that in titanium carbonitride lower layer. Specifically, the percentage of acetonitrile gas introduced in the second stage of coating the titanium carbonitride layer is not less than 1.5 times as much as the percentage of acetonitrile gas used in the first stage of coating the titanium carbonitride layer, thereby enabling reliable control.

Regarding the above film coating conditions, in the growth process of columnar titanium carbonitride crystals, the percentage ($V_A$) of $CH_3CN$ (acetonitrile) gas is controlled to 0.1 to 3 vol. % and controlled to a low concentration so that the ratio ($V_A/V_H$) of the percentage ($V_A$) of $CH_3CN$ gas to the percentage ($V_H$) of $H_2$ gas as carrier gas can be 0.03 or less. This enables fine nucleus to be produced and the adhesive force of the titanium carbonitride layer to be improved.

Regarding the above film coating conditions, when the percentage of acetonitrile ($CH_3CN$) gas in the reactive gas is less than 0.1 vol. %, titanium carbonitride crystals cannot grow to columnar crystals and they become particulate crystals. Conversely, when the percentage ($V_A$) of $CH_3CN$ gas in the reactive gas is more than 3 vol. %, the mean crystal width of titanium carbonitride crystals is enlarged, making it impossible to control the ratio.

In addition, when the titanium carbonitride upper layer is coated, the amount of introduced $CH_3CN$ gas in the reactive gas is changed as mentioned above and, if desired, a film coating temperature is adjusted. This makes it possible to set the mean crystal width of titanium carbonitride crystals to a predetermined structure.

Next, if desired, a middle layer may be coated. For example, when TiCNO layer is coated as the middle layer 11, a mixed gas composed of 0.1 to 3 vol. % of titanium chloride ($TiCl_4$) gas, 0.1 to 10 vol. % of methane ($CH_4$) gas, 0.01 to 5 vol. % of carbon dioxide ($CO_2$) gas, 0 to 60 vol. % of nitrogen ($N_2$) gas and hydrogen ($H_2$) gas for the rest is prepared and introduced into a reactor. The inside of the reactor is set at 800 to 1100°C and 5 to 30 kPa.

Then, the aluminum oxide layer 4 is coated. A desirable method for coating the aluminum oxide layer 4 is to use a mixed gas composed of 3 to 20 vol. % of aluminum chloride ($AlCl_3$) gas, 0.5 to 3.5 vol. % of hydrogen chloride (HCl) gas, 0.01 to 5.0 vol. % of carbon dioxide ($CO_2$) gas, 0 to 0.01 vol. % of hydrogen sulfide ($H_2S$) gas and hydrogen ($H_2$) gas for the rest and set a temperature to 900 to 1100°C and a pressure to 5 to 10 kPa.

To form the surface layer (TiN layer) 12, a mixed gas composed of 0.1 to 10 vol. % of titanium chloride ($TiCl_4$) gas, 0 to 60 vol. % of nitrogen ($N_2$) gas and hydrogen ($H_2$) gas for the rest as reactive gas composition is prepared and introduced into a reactor. The inside of the reactor may be set at 800 to 1100°C and 50 to 85 kPa.

At this time, in addition to the aforementioned method, after the coating layer 3 is formed through the above chemical vapor deposition method, a cooling rate to 700°C in the reactor is set to 12 to 30°C /minute. Thereby, it is possible to control the adhesive force of the upper layer 4 and the lower layer 5 in the above specific range.

If desired, at least the cutting edge part on the surface of the coating layer 3 is polished. This polishing process relieves residual stress remaining in the coating layer 3 and provides a tool with better fracture resistance.

The present invention is not limited to the above embodiment. For example, as a matter of course, the upper layer 4 and/or the lower layer 5 may be a single layer. Also, the above description illustrates the case of using chemical vapor deposition (CVD) method as film coating method, but physical vapor deposition (PVD) method may be used to form a part of the coating layer or the entire coating layer.

For example, through ion plating method, the upper layer 4 and the lower layer 5 can be combined as a structure of TiAIN layer-TiCN layer, a structure of TiCrN layer-TiAIN layer, a structure of DLC layer-CrSiBN layer or the like. By controlling the adhesive force of each layer in the above range, it is possible to manufacture a surface coated member which has not only good resistance to fracture and wear but also, in some cases, is excellent in tribology property, reaction resistance to work materials or slided materials and appearance.

(Second embodiment)

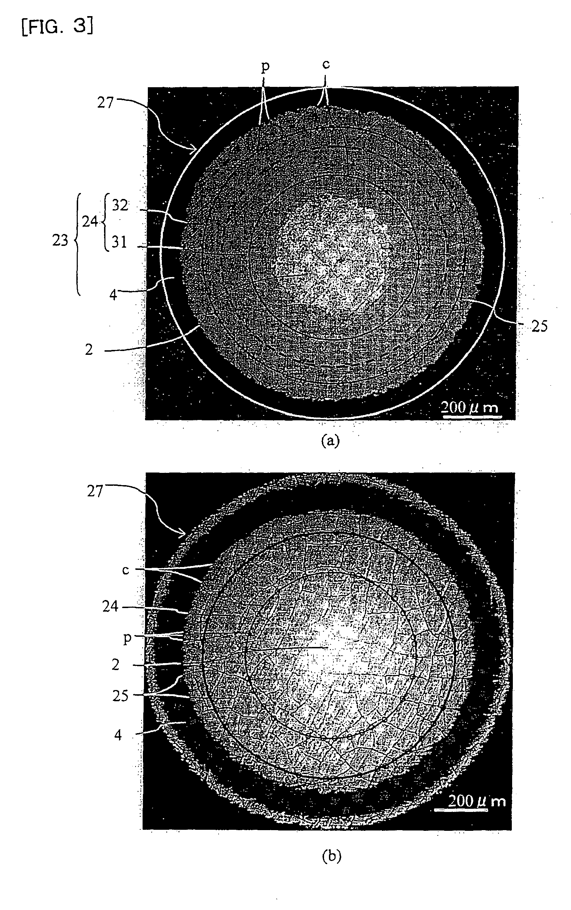

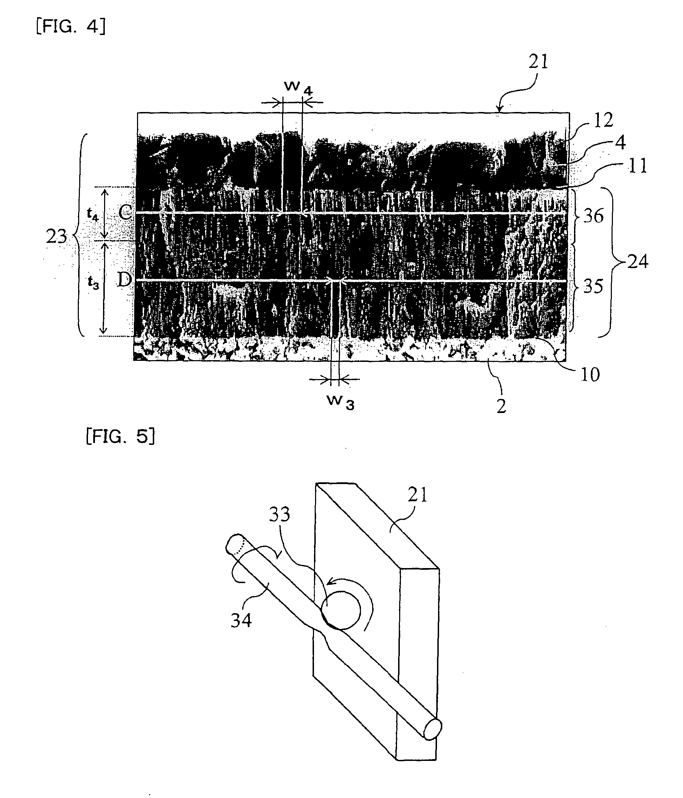

The second embodiment of a surface coated cutting tool which is a good example of the surface coated member of the present invention will be described with reference to Fig. 3 and Fig. 4. Fig. 3 is a metallographic microscope image of a depression in Calotest.

Fig. 3 (a) shows this embodiment and Fig. 3 (b) shows a comparative example. Fig. 4 is a photograph of the cutting surface including a hard coating layer taken with a scanning electron microscope (SEM). Since the basic film structure of Fig. 4 is identical to Fig. 1, some parts overlapping the first embodiment are identified by the same reference numerals as in Fig. 1 and their description is omitted.

According to Fig. 3 and Fig. 4, a surface coated cutting tool (hereinafter, referred to simply as tool) 21 comprises a substrate 2 and a hard coating layer 23 formed on the surface of the substrate 2 through chemical vapor deposition (CVD) method.

According to this embodiment, as shown in Fig. 4, the hard coating layer 23 comprises at least a titanium carbonitride (TiCN) layer 24 and an aluminum oxide layer 4 as its upper layer. In Fig. 3, a depression 27 of Calotest is observed, for example, at a magnification of 40 to 500 (at a magnification of 50 in Fig. 3) with a metallographic microscope or a scanning electron microscope (with a metallographic microscope in Fig. 3).

Calotest provided as an evaluation item of the present invention is as follows. As shown in Fig. 5, putting a hard ball 33 made of metal or cemented carbide on the surface of the tool 21, namely, the surface of the hard coating layer 23, a support rod 34 that supports the hard ball 33 is rotated and the hard ball 33 is rolled. Thereby, the tool 21 is partially worn down and the hard coating layer 23 is worn down to a spherical surface so that the substrate 2 can be exposed at the center of the depression 27 as shown in Fig. 3. In general, Calotest is a method for estimating the thickness of each layer by observing the width of each layer of the hard coating layer 23 observed in the depression 27.

According to the present invention, the depression 27 of the above Calotest is obtained by wearing down the hard coating layer 23 to a spherical surface so that the substrate 2 can be exposed at the center of the depression 27. It is found that the conditions and characteristics of the hard coating layer 23 can be evaluated by observing each layer in terms of wear, peeling expansion of cracks 25 in each layer of the hard coating layer 23 included in the depression 27.

According to the present invention, in observing the depression 27 of Calotest, as shown in Fig. 3 (a), the titanium carbonitride layer 24 which is observed at the periphery of the substrate 2 exposed at the center of the depression 27 has a lower structure 31 and an upper structure 32. The lower structure 31 has no or few cracks. The upper structure 32 is observed at the periphery of the lower structure 31 and has higher density of cracks than the lower structure 31.

In the present invention, variations in the density of cracks can be quantified by the number of cracks, the average size of each exposed part surrounded by cracks, the crack spacing and the like. For example, a method for quantifying variations in the density of cracks by average crack spacing will be described with reference to Fig. 3. As shown in Fig. 3, when observing the surface of the depression in a metallographic micrograph after wear in Calotest, cracks 25 are observed in the titanium carbonitride layer 24 that is observed at the periphery of the substrate exposed at the center of the depression. As for the cracks 25, the average crack spacing in the present invention represents an average distance between cracks when a given line L is drawn in a photograph, based on a basic idea of intercept method. Specifically, first, a given circle c is drawn in a photograph and the number of cracks 25 on the circumference of the circle c is observed. The length obtained by dividing a circumferential length L by the number of cracks 25 on the above circumference stands for the average crack spacing (average distance between cracks).

Moreover, in order to increase the adhesive force between the titanium carbonitride layer 24 and the aluminum oxide layer 4 and inhibit the crack expansion of the titanium carbonitride layer 24 itself, it is desirable that the ratio $(y/x)$ of an average crack spacing $y$ observed in the upper structure 32 to an average crack spacing $x$ observed in the lower structure 31 of the titanium carbonitride layer 24 is not more than 0.5. When the lower structure 31 has no cracks, calculations are made on the basis of x=infinity and y/x=0. The average crack spacing in the lower structure 31 may be not less than 80 $\mu$m.

In the tool of this embodiment, even if a large impact is suddenly brought on the hard coating layer 23, thanks to the above structure, cracks 25 occur preferentially in the upper structure 32 that is the surface side of the titanium carbonitride layer 24. Thereby, stress is relieved and the impact can be absorbed without chipping and fracture in the hard coating layer 23 caused by another large crack. By contrast, in a conventional tool, peeling occurs in the interface part where residual stress is caused by the difference in thermal expansion coefficient between the aluminum oxide layer and the titanium carbonitride layer during cooling after coating. Furthermore, in this embodiment, the presence of the lower structure 31 of the titanium carbonitirde layer 24 where cracks 25 are hardly produced prevents the expansion of cracks 25 produced in the upper structure 32 and therefore neither chipping nor peeling occurs in the titanium carbonitride layer 24. Consequently, chipping and peeling in the entire hard coating layer 23 can be prevented and wear resistance in the entire hard coating layer 23 can be improved. Thereby, it is possible to obtain the tool 21 having good resistance to fracture and chipping.

Namely, in the observation of the depression 27, if there are no cracks 25 in the upper structure 32 of the titanium carbonitride layer 24, residual stress between the titanium carbonitride layer 24 and the aluminum oxide layer 4 cannot be relieved. If a large impact is brought on the hard coating layer 23, large cracks 25 expand at a stretch in either or both of the titanium carbonitride layer 24 and the aluminum oxide layer 4, and large chipping and sudden fracture are apt to occur in the hard coating layer 23.

As shown in Fig. 3 (b), when cracks 25 are produced at the same rate in the entire titanium carbonitride layer 24, namely, when cracks are equally spaced throughout the titanium carbonitride layer 24, cracks caused by residual stress with the aluminum oxide layer 4 that have been underlying since before cutting or cracks 25 caused by an impact during cutting promptly expand throughout the titanium carbonitride layer 24. In this case as well, chipping and fracture easily occur in the hard coating layer 23.

If the part where the substrate 2 is exposed is too large or too small, in some cases, it may be impossible to precisely observe cracks 25 in the titanium carbonitride layer 24. Therefore, the wear conditions of Calotest (e.g. time, type of a hard ball, abrading agent) may be adjusted so that the diameter of the substrate 2 exposed in the depression 27 can be 0.1 to 0.6 times as large as the diameter of the entire depression 27.

In the observation of the depression of Calotest, it is desirable that the relational expression x/y of an average crack spacing x observed in the upper structure of the titanium carbonitride layer 24 to an average crack spacing y observed in the lower structure 31 is not more than 0.5, in particular, not more than 0.2. This makes it possible to optimize a production rate of cracks in the titanium carbonitride layer 24. This also makes it possible to increase adhesion between the titanium carbonitride layer 24 and the aluminum oxide layer 4 and inhibit the crack expansion of the titanium carbonitride layer 24 itself. As a result, resistance to chipping and fracture is improved in the entire hard coating layer 23 and wear resistance is maintained in the tool 21.

In addition, a crack spacing in the lower structure 31 is desirably not less than 80 $\mu$m, especially, not less than 100 $\mu$m and more desirably not less than 150 $\mu$m, because the lower structure 31 of the titanium carbonitride layer 24 has a structure that hardly allows cracks to expand, which leads to increased strength in the titanium carbonitride layer 24 and improved resistance to fracture and chipping in the entire hard coating layer 23.

According to Fig. 4 showing a scanning electron microscope image in the fracture surface of the tool 21 of Fig. 3, the titanium carbonitride layer 24 comprises a multilayer, namely, a lower titanium carbonitride layer 35 and an upper titanium carbonitride layer 36. The lower titanium carbonitride layer 35 is observed at the periphery of the substrate 2 exposed at the center of the depression 27 and has no cracks or wide average crack spacing. The upper titanium carbonitride layer 36 is observed around the lower titanium carbonitride layer 35 and has narrower average crack spacing than the lower titanium carbonitride layer 35. Thanks to this structure, it is possible to effectively prevent cracks 25 produced in the upper part of the titanium carbonitirde layer 24 from expanding and reaching the bottom part and to surely prevent chipping and fracture in the hard coating layer 3.

Desirably, the upper titanium carbonitride layer 36 has a film thickness $t_4$ of 0.5 $\mu$m $\leq t_4 \leq$ 5 $\mu$m, the lower titanium carbonitride layer 35 has a film thickness $t_3$ of 1 $\mu$m $\leq t_3 \leq$ 10 $\mu$m and the relation of $1 < t_3/t_4 \leq 5$ is satisfied, because this makes it possible to prevent cracks 25 of the titanium carbonitride layer 24 itself from expanding while increasing adhesion between the titanium carbonitride layer 24 and the aluminum oxide layer 4 and to prevent chipping and fracture and maintain high wear resistance in the entire tool 21 while increasing impact resistance in the entire hard coating layer 23.

As shown in Fig. 4, titanium carbonitride particles in the titanium carbonitride layer 24 grow in a direction vertical to the surface of the substrate 2 and have a columnar structure. The upper titanium carbonitride layer 36 has a columnar structure where the mean crystal width $w_4$ of titanium carbonitride particles is large and the lower titanium carbonitride layer 35 has a columnar structure where the mean crystal width $w_3$ of titanium carbonitride particles is small. This makes it possible to prevent cracks 25 produced in the upper titanium carbonitride layer 36 from expanding through the lower titanium carbonitride layer 35 and to control adhesive force between the aluminum oxide layer 4 and the titanium carbonitride layer 24 while reducing residual stress between the both and minimizing the occurrence of cracks. This is desirable because resistance to wear and peeling can be enhanced in the hard coating layer 23 and resistance to wear and fracture can be optimized in the entire tool 21.

Herein, the titanium carbonitride particles having a columnar structure which grow in a direction vertical to the surface of the substrate 2 represent a crystal structure wherein the ratio:[a crystal length in a direction vertical to the interface with the substrate 2] /[a mean crystal width], namely, the aspect ratio is not less than 2. In the observation of a structure in the cutting surface as shown in Fig. 4, the hard coating layer 23 may be mixed crystals containing not more than 30 area % of particulate titanium carbonitride crystals.

In this case, desirably, the mean crystal width $w_4$ in the upper titanium carbonitride layer 36 of the titanium carbonitride layer 24 is 0.2 to 1.5 $\mu$m, in particular, 0.2 to 0.5 $\mu$m, and the ratio ($w_3/w_4$) of the mean crystal width $w_3$ in the lower titanium carbonitride layer 35 to the mean crystal width $w_4$ in the upper titanium carbonitride layer 36 is not more than 0.7, in particular, not more than 0.5. This is because resistance to fracture and chipping can be enhanced in the titanium carbonitride layer 24 itself and resistance to wear and fracture can be also enhanced in the entire hard coating layer 23 by controlling the adhesive force to the aluminum oxide layer 4.

The method for measuring the mean crystal width of titanium carbonitride particles composed of columnar crystals in the present invention is as follows. The cross-sectional surface including the hard coating layer 23 is observed through a scanning electron micrograph. A straight line is drawn parallel to the interface between the substrate 2 and the hard coating layer 23 in the region of each height of the titanium carbonitride layer 24 (see line segments C and D in Fig. 4). The mean crystal width w is obtained by dividing an average value of width of each particle in this line segment, namely, length of line segment by the number of grain boundaries cutting across the line segment.

When the titanium carbonitride layer 24 (the lower titanium carbonitride layer 35 and the upper titanium carbonitride layer 36) is represented by Ti ($C_{1-m}N_m$), it is desirable that m is 0.55 to 0.80 in the lower titanium carbonitride layer 35 and that m is 0.40 to 0.55 in the upper titanium carbonitride layer 36, because it is possible to prevent cracks produced in the upper titanium carbonitride layer 36 from expanding through the lower titanium carbonitride layer 35 and increase resistance to chipping and fracture in the hard coating layer 23.

As in the first embodiment, as a bottom layer 10 between the substrate 2 and the titanium carbonitride layer 24, as a middle layer 11 between the titanium carbonitride layer 24 and the aluminum oxide layer 4, as a titanium carbonitride interlayer (not shown in drawings) between the layers constituting the titanium carbonitride layer 24 being multilayer, and as a surface layer 12 on the upper layer of the aluminum oxide layer 4 , at least one layer selected from the group consisting of titanium nitride (TiN) layer, titanium carbide (TiC) layer, titanium oxycarbonitride (TiCNO) layer, titanium oxycarbide (TiCO) layer and titanium oxynitride (TiNO) layer may be coated. Thereby, it is possible to prevent the components of the substrate 2 from diffusing, increase adhesive force between the respective layers of the hard coating layer 23 and control the structure, crystal structure, adhesive force and occurrence of cracks of the titanium carbonitride layer 24 and the aluminum oxide layer 4. In particular, it is preferable that a titanium nitride layer is coated as the bottom layer 10.

(Manufacturing method)

Next, the method for manufacturing a surface coated cutting tool according to the second embodiment mentioned above will be described. Basically, the same manufacturing method as in the first embodiment can be applied. It should be noted in this embodiment that in the first stage of coating the titanium carbonitride layer (when the lower titanium carbonitride layer 35 is coated), the temperature inside a reactor is set to 800 to 840°C and that in the second stage of coating the titanium carbonitride layer (when the upper titanium carbonitride layer 36 is coated), the temperature inside a reactor is set to 860 to 900°C and the percentage of acetonitrile ($CH_3CN$) gas in the reactive gas to be used is larger than that of $CH_3CN$ gas used in the first stage of coating the titanium carbonitride layer. This enables the upper titanium carbonitride layer 36 to have higher density of cracks than the lower titanium carbonitride layer 35.

After a hard coating layer is coated through chemical vapor deposition method, a cooling rate to 700°C in a reactor is controlled at 12 to 30°C /minute so that given cracks in the structure of the titanium carbonitride layer can be observed in the above Calotest.

The above description of the first and the second embodiments illustrates an example where the surface coated member of the present invention is applied to a cutting tool. However, the present invention is not limited to this and can be suitably used for structural materials requiring resistance to wear and fracture, e.g. wear resistant materials such as excavating tools, molds and sliding members.

The surface coated member of the present invention will be described in detail with reference to examples, but it should be noted that the present invention is not limited to the following examples only.

[Example I]

To tungsten carbide (WC) powder having a mean particle size of 1.5 μm, 6 % by weight of cobalt (Co) powder having a mean particle size of 1.2 μm, 0.5 % by weight of titanium carbide (TiC) powder having a mean particle size of 2.0 μm and 5 % by weight of tantalum carbide (TaC) powder were added, mixed and molded into an insert (CNMA120412) by press molding, followed by debinding process, and then sintering was performed in a vacuum of 0.01 Pa at 1500°C for one hour. Thereby, cemented carbide was prepared. In addition, a cutting edge (honing R) was processed into the cemented carbide so prepared through brushing from the rake face. The arithmetical mean surface roughness (Ra) based on JISB0601-2001 was 1.1 μm on the flank face of the substrate so obtained and the arithmetical mean surface roughness (Ra) was 0.4 μm on the rake face.

Next, through CVD method, a coating layer composed of a multilayer having the composition shown in Table 2 was coated on the above cemented carbide. The film coating conditions of each layer in Table 2 were presented in Table 1. In Table 1, TiCN5 was coated, continuously changing the percentage ($V_A$) of $CH_3CN$ gas in the reactive gas from 1.1 vol. % to 1.8 vol. %. The surface of the coating layer underwent brushing from the rake face side for 30 seconds to prepare surface coated cutting tools of Sample Nos. I-1 to I-9.

Under the following conditions, scratch test was conducted on the flank face of the cutting tools so obtained. Observing a scratch track, the state of interlayer peeling and the load under which a coating layer starts to peel away from the substrate were checked. As a result, the upper layer in the interlayer peeling of the coating layer was identified as the aluminum oxide ($Al_2O_3$) layer and the lower layer in the beginning of peeling of the coating layer from the substrate was identified as the titanium carbonitride (TiCN) layer. Adhesive force was also figured out for each layer.

Equipment: CSEM-REVETEST commercially available from Nanotec Corporation

Indenter: Spherical diamond indenter (diamond stylus manufactured by Tokyo Diamond Tools Mfg. Co., Ltd.)

Measurement conditions are as mentioned above.

Polishing was carried out so as to observe the coating layer mentioned in Table 2 with a transmission electron microscope (TEM). Observing the structure from the surface direction of each layer, the structure of titanium carbonitride particles in the surface direction was specified and the average aspect ratio was measured. Furthermore, photographs were taken with a scanning electron microscope (SEM) at any five points on a cutting surface including the cross-sectional surface of the coating layer. Observing the structure of titanium carbonitride particles in each photograph, the average aspect ratio in a cross-sectional direction and the mean crystal width w of titanium carbonitride particles were measured. Regarding the samples having a multi-layer titanium carbonitride layer, as shown in Fig. 1, the lines A and B were drawn in a position 1 μm high from the substrate side for the lower layer and in a position 0.5 μm high from the surface side for the upper layer, in relation to the total film thickness. The number of grain boundaries cutting across each line segment was measured and converted into a crystal width of titanium carbonitride particles, and the mean crystal width was found out by averaging the crystal widths which were respectively figured out at the photographed five points.

[Table 1]

| Coating layer | Composition of mixed gas (% by volume) | (% by volume) (% by volume) | $V_A/V_H$ | Temperature (°C) | Pressure (kPa) |
|---|---|---|---|---|---|
| Base layer (TiN) | TiCl$_4$:0.5, N$_2$:33, H$_2$:the rest | - | | 900 | 16 |
| TiCN1<c> | TiCl$_4$:1.0, N$_2$:43, CH$_3$CN,H$_2$:the rest | 1.1 | 0.020 | 865 | 9 |
| TiCN2<c> | TiCl$_4$:1.0, N$_2$:43, CH$_3$CN,H$_2$:the rest | 1.5 | 0.028 | 865 | 9 |

(continued)

| Coating layer | Composition of mixed gas (% by volume) | (% by volume) (% by volume) | $V_A/V_H$ | Temperature (°C) | Pressure (kPa) |
|---|---|---|---|---|---|
| TiCN3<c> | $TiCl_4$:1.0, $N_2$:43, $CH_3CN$,$H_2$:the rest | 1.8 | 0.033 | 865 | 9 |
| TiCN4<c> | $TiCl_4$:1.0, $N_2$:25, $CH_3CN$,$H_2$:the rest | 2.2 | 0.031 | 1015 | 20 |
| TiCN5<c> | $TiCl_4$:1.0, $N_2$:43, $CH_3CN$,$H_2$:the rest | 1.1 →1.8 | 0.020 →0.033 | 865 | 9 |
| TiCN<p> | $TiCl_4$:0.8, $N_2$:25, $CH_4$:7, $H_2$:the rest | - | | 1020 | 30 |
| TiCNO | $TiCl_4$:0.7, $CH_4$:4, $N_2$:5, $CO_2$:0.01, $H_2$:the rest | - | | 1010 | 10 |
| TiCO | $TiCl_4$:0.7, $CH_4$:4, $CO_2$:0.02,$H_2$:the rest | - | | 1010 | 10 |
| TiNO | $TiCl_4$:0.7, $CH_4$:4, $N_2$:5, $H_2$:the rest | - | | 1010 | 10 |
| $\alpha$-$Al_2O_3$ | $AlCl_3$:15, HCl:2, $CO_2$:4, $H_2S$:0.01, $H_2$:the rest | - | | 1005 | 6 |
| $\kappa$ - $Al_2O_3$ | $AlCl_3$:15, HCl:2, $CO_2$:4, $H_2S$:0.01, $H_2$:the rest | - | | 1005 | 6 |
| Surface layer (TiN) | $TiCl_4$:0.5, $N_2$:44, $H_2$:the rest | - | | 1010 | 80 |
| TiCN<c> and TiCN<p> respectively represent columnar TiCN and particulate TiCN. $V_A$ represents the percentage of acetonitrile in the reactive gas. $V_A/V_H$ represents the ratio of the percentage $V_A$ of acetonitrile gas to the percentage $V_H$ of hydrogen gas. | | | | | |

[Table 2]

| Coating layer | Composition of mixed gas (% by volume) | $V_A$ (% by volume) | $V_A/V_H$ | Temperature (°C) | Pressure (kPa) |
|---|---|---|---|---|---|
| Base layer (TiN) | $TiCl_4$:0.5, $N_2$:33, $H_2$:the rest | - | | 900 | 16 |
| TiCN1<c> | $TiCl_4$:1.0, $N_2$:43, $CH_3CN$,$H_2$:the rest | 1.1 | 0.020 | 865 | 9 |
| TiCN2<c> | $TiCl_4$:1.0, $N_2$:43, $CH_3CN$,$H_2$:the rest | 1.5 | 0.028 | 865 | 9 |

(continued)

| Coating layer | Composition of mixed gas (% by volume) | $V_A$ (% by volume) | $V_A/V_H$ | Temperature (°C) | Pressure (kPa) |
|---|---|---|---|---|---|
| TiCN3<c> | $TiCl_4$:1.0, $N_2$:43, $CH_3CN$,$H_2$:the rest | 1.8 | 0.033 | 865 | 9 |
| TiCN4<c> | $TiCl_4$:1.0, $N_2$:25, $CH_3CN$,$H_2$:the rest | 2.2 | 0.031 | 1015 | 20 |
| TiCN5<c> | $TiCl_4$:1.0, $N_2$:43, $CH_3CN$,$H_2$:the rest | 1.1 →1.8 | 0.020 →0.033 | 865 | 9 |
| TiCN<p> | $TiCl_4$:0.8, $N_2$:25, $CH_4$:7, $H_2$:the rest | - | | 1020 | 30 |
| TiCNO | $TiCl_4$:0.7, $CH_4$:4, $N_2$,:5, $CO_2$:0.01, $H_2$:the rest | - | | 1010 | 10 |
| TiCO | $TiCl_4$:0.7, $CH_4$:4, $CO_2$:0.02. $H_2$:the rest | - | | 1010 | 10 |
| TiNO | $TiCl_4$:0.7, $CH_4$:4, $N_2$:5, $H_2$:the rest | - | | 1010 | 10 |
| $\alpha$-$Al_2O_3$ | $AlCl_3$:15, HCl:2, $CO_2$:4, $H_2S$: 0.01, $H_2$:the rest | - | | 1005 | 6 |
| $\kappa$-$Al_2O_3$ | $AlCl_3$:15, HCl:2, $CO_2$:4, $H_2S$: 0.01, $H_2$:the rest | - | | 1005 | 6 |
| Surface layer (TiN) | $TiCl_4$:0.5, $N_2$:44, $H_2$:the rest | - | | 1010 | 80 |

TiCN<c> and TiCN<p> respectively represent columnar TiCN and particulate TiCN.
$V_A$ represents the percentage of acetonitrile in the reactive gas.
$V_A/V_H$ represents the ratio of the percentage $V_A$ of acetonitrile gas to the percentage $V_H$ of hydrogen gas.

Using the cutting tools so obtained, continuous cutting test and interrupted cutting test were conducted under the following conditions to evaluate resistance to wear and fracture. The results were presented in Table 3.
(Continuous cutting conditions)
Work material: Ductile cast iron sleeve form with four grooves (FCD700)
Insert: CNMA120412
Cutting speed: 250 m/minute
Feed rate: 0.3 mm/rev
Depth of cut: 2 mm
Cutting time: 20 minutes
Others: Water-soluble cutting fluid is used.
Evaluation item: Observing a cutting edge under a microscope, wear on the flank and wear at the tip are measured.
(Interrupted cutting conditions)
Work material: Ductile cast iron sleeve form with four grooves (FCD700)
Insert: CNMA120412
Cutting speed : 250 m/minute
Feed rate: 0.3 to 0.5 mm/rev

Depth of cut: 2 mm
Others: Water-soluble cutting fluid is used.
Evaluation item: Number of impacts before fracture
The state of peeling of a coating layer of a cutting edge is observed under a microscope after 1000 impacts are given.

[Table 3]

| Sample No. | Coating layer * | | | | | | | Cooling rate (°C/min.) | $F_L/F_U$ | Observation in cross-sectional direction | | Observation in surface direction | |
| | Base layer | TiCN layer | | | Middle layer | $Al_2O_3$ layer | Surface layer | | | TiCN particle | Aspect ratio | TiCN particle | Aspect ratio |
| | | First layer | Second layer | Third layer | | | | | | | | | |
|---|---|---|---|---|---|---|---|---|---|---|---|---|---|
| I-1 | TiN (0.5) | TiCN1<c> (6.0)[0.3] | TiCN4<c> (3.0)[1.0] | - | TiCNO (0.5) | α-$Al_2O_3$ (2.0) | TiN (0.2) | 20 | 3.1 | Column | 13 | Acicular | 5 |
| | → | → | 140N($F_L$) | | → | 45N ($F_U$) | <5N | | | | | | |
| I-2 | TiN (0.6) | TiCN1<c> (3.0)[0.3] | TiN (0.5) | TiCN4<c> (0.8)[1.0] | TiCO (1) | α-$Al_2O_3$ (4.0) | TiN (0.5) | 20 | 1.14 | Column | 10 | Acicular | 6 |
| | → | → | → | 80N($F_L$) | → | 70N ($F_U$) | <5N | | | | | | |
| I-3 | TiN (1) | TiCN1<c> (3.0)[0.3] | TiCN3<c> (2.0)[0.9] | - | TiNO (0.3) | α, κ-$Al_2O_3$ (20) | TiN (1) | 15 | 15.0 | Column | 14 | Acicular | 6 |
| | → | → | 150N($F_L$) | | → | 10N ($F_U$) | <5N | | | | | | |
| I-4 | Nothing | TiCN<p> (0.5)[-] | TiCN1<c> (3.0)[0.5] | TiCN3<c> (4.0)[0.9] | TiCNO (0.1) | α,κ-$Al_2O_3$ (5.0) | Nothing | 25 | 2.3 | Column | 8 | Acicular | 3 |
| | | → | → | 80N($F_L$) | → | 35N ($F_U$) | | | | | | | |
| I-5 | TiN (0.6) | TiCN1<c> (4.0)[0.3] | TiCN3<c> (3.0)[0.8] | - | TiCNO (0.3) | κ-$Al_2O_3$ (2.0) | TiN (1) | 15 | 6.0 | Column | 7 | Acicular | 5 |
| | → | → | 150N($F_L$) | | → | 25N ($F_U$) | <5N | | | | | | |
| I-6 | Nothing | TiCN2<c> (1.0)[0.3] | TiCN3<c> (4.0)[0.9] | TiCN4<c> (2.0)[1.0] | TiCO (1) | α-$Al_2O_3$ (4.0) | TiN (0.5) | 25 | 1.3 | Column | 8 | Acicular | 4 |
| | | → | → | 65N($F_L$) | → | 50N ($F_U$) | <5N | | | | | | |

| Sample No. | Coating layer * | | | | | | | Cooling rate (°C/min.) | $F_L/F_U$ | Observation in cross-sectional direction | | Observation in surface direction | |
| --- | --- | --- | --- | --- | --- | --- | --- | --- | --- | --- | --- | --- | --- |
| | Base layer | TiCN layer | | | Middle layer | $\alpha$-Al$_2$O$_3$ layer | Surface layer | | | TiCN particle | Aspect ratio | TiCN particle | Aspect ratio |
| | | First layer | Second layer | Third layer | | | | | | | | | |
| I-7 | TiN (0.6) | TiCN3<c> (0.3)[0.8] | TiCN3<c> (3.0)[0.8] | - | TiCNO (1.5) | α-Al$_2$O$_3$ (5.0) | Nothing | 10 | 1.0 | Column | 3 | Isotropic | 1.2 |
| | → | → | → | | → | 80N ($F_L$.$F_U$) | | | | | | | |
| I-8 | Nothing | TiCN3<c> (0.3)[0.8] | TiCN2<c> (3.0)[0.4] | - | TiCNO (0.5) | α-Al$_2$O$_3$ (3.0) | TiN (0.2) | 20 | 1.03 | Column | 6 | Isotropic | 1.5 |
| | | → | 33N($F_L$) | | → | 32N ($F_U$) | <5N | | | | | | |
| I-9 | TiN (0.6) | TiCNI<c> (7.0)[0.3] | - | - | - | κ-Al$_2$O$_3$ (7.0) | TiN (0.2) | 40 | 33.0 | Column | 20 | Acicular | 8 |
| | → | 100N($F_L$) | | | | → | 3N($F_U$) | | | | | | |
| I-10 | Nothing | TiCN5<c> (6.0)[0.5] - | | - | TiCNO (0.1) | α-Al$_2$O$_3$ (10.0) | TiN (0.2) | 20 | 29.0 | Column | 10 | Acicular | 4 |
| | | 145N($F_L$) | | | → | 5N($F_U$) | 3N($F_U$) | | | | | | |

*( ) represents layer thickness and [ ] represents a mean crystal width. Unit: $\mu$m TiCN<c> and TiCN<p> respectively represent columnar TiCN and particulate TiCN.
The peeling load (N) of each layer is shown at the bottom of each coating layer. '→' means that the layer peels together with a layer on it.

As apparent from Tables 1 to 3, Sample Nos. I-7 and I-8 where the ratio $F_L/F_U$ was less than 1.1 had chipping and poor fracture resistance. In Sample No. I-9 whose $F_L/F_U$ ratio was over 30, $Al_2O_3$ layer peeled earlier and progress of wear was accelerated. By contrast, in any of Sample Nos. I-1 to I-6 and I-10 whose $F_L/F_U$ ratio was controlled within the range of 1.1 to 30 according to the present invention, the coating layers did not peel. In particular, Sample Nos. I-1 and I-4 to I-6 where the ratio $F_L/F_U$ was controlled within the range of 1.2 to 10 endured a larger number of impacts in interrupted cutting test. Moreover, Sample Nos. I-1 and I-4 where the ratio $F_L/F_U$ was controlled within the range of 1.5 to 5 had a long life both in continuous cutting and interrupted cutting and excellent cutting performance in terms of resistance to fracture and chipping.

[Example II]

Through ion plating method, a coating layer was coated on an ultrafine cemented carbide substrate mainly composed of WC particles having a mean particle size of 0.3 $\mu$m. The coating layer consisted of two layers, namely, TiAlCrN layer (2 $\mu$m thick) as lower layer and $MoS_2$ layer (1 $\mu$m thick) as upper layer. Then, scratch strength was evaluated in the same manner as in Example 1. As a result, it was found that $F_U$ (upper layer) was 30N, $F_L$ (lower layer) was 80N and the ratio $F_L/F_U$ was 2.7. When a throw-away tip for internal diameter was prepared so as to have this structure and used for cutting, it proved practical, having excellent resistance to wear and fracture.

[Example III]

Through ion plating method, a coating layer was coated on a substrate composed of alloy steel. The coating layer consisted of three layers, namely, titanium carbonitride (TiCN) layer (1 $\mu$m thick) as first layer, TiAlN layer (2 $\mu$m thick) as second layer and CrN layer (0.5 $\mu$m thick) as third layer. Then, scratch strength was evaluated in the same manner as in Example I. As a result, it was found that $F_U$ (upper layer: TiAlN layer) was 40N, $F_L$ (lower layer: TiCN layer) was 60N and the ratio $F_L/F_U$ was 1.3. A mold was prepared so as to have this structure and molding test was conducted. Consequently, it became clear that the mold was practical, having excellent resistance to wear and fracture.

[Example IV]

In the same manner as Example 1, cemented carbide was prepared. A cutting edge (honing R) was processed through brushing into the cemented carbide so prepared. The surface coated cutting tools of Sample Nos. IV-1 to IV-7 were prepared by coating, on the cemented carbide, a hard coating layer which was composed of a multilayer coated under the conditions shown in Table 4 through CVD method and had the composition shown in Table 5. Sample No. IV-7 in Table 5 was prepared so that the titanium carbonitride layer had gradient structure by continuously increasing the percentage of acetonitrile ($CH_3CN$) gas in the mixed gas as mentioned in the condition of titanium carbonitride (TiCN) layer 5 in Table 4.

[Table 4]

| Coating layer | Composition of mixed gas (% by volume) | Percentage of $CH_3CN$ gas in mixed gas (% by volume) | Deposition temperature (°C) | Pressure (kPa) |
|---|---|---|---|---|
| Bottom layer TiN | $TiCl_4$:0.5, $N_2$:33, $H_2$: the rest | - | 900 | 16 |
| TiCN1<c> | $TiCl_4$:1.0, $N_2$:40, $H_2$: the rest | 1.1 | 825 | 9 |
| TiCN2<c> | $TiCl_4$:1.0, $N_2$:40, $H_2$: the rest | 1.5 | 840 | 9 |
| TiCN3<c> | $TiCl_4$:1.0, $N_2$:40, $H_2$: the rest | 1.8 | 865 | 15 |
| TiCN4<c> | $TiCl_4$:1.0, $N_2$:40, $H_2$: the rest | 1.7 | 900 | 15 |

(continued)

| Coating layer | Composition of mixed gas (% by volume) | Percentage of $CH_3CN$ gas in mixed gas (% by volume) | Deposition temperature (°C) | Pressure (kPa) |
|---|---|---|---|---|
| TiCN5<c> | $TiCl_4$:1.0, $N_2$:40, $H_2$: the rest | 1.1→1.8 (continuously increasing) | 825~900 (continuously raising temperature) | 9 |
| TiCNO | $TiCl_4$:0.7, $CH_4$:4, $N_2$:5, $CO_2$:0.01, $H_2$:the rest | - | 1010 | 10 |
| $\alpha$-$Al_2O_3$ | $AlCl_3$:15, HCl:2, $CO_2$:4, $H_2S$:0.01, $H_2$:the rest | - | 1005 | 6 |
| Uppermost layer TiN | $TiCl_4$:0.5, $N_2$:44, $H_2$: the rest | - | 1010 | 80 |

As for the tools so obtained, photographs were taken with a scanning electron microscope (SEM) at five points on any cutting surface or a polished surface including the cross-sectional surface of the hard coating layer, and the structure of the titanium carbonitride layer was observed in each photograph. At this time, as shown in Fig. 4, the lines C and D were drawn in a position one fifth as high as the total film thickness from the substrate side and in a position one fifth as high as the total film thickness from the aluminum oxide layer (surface) side, in relation to the total film thickness of the titanium carbonitride layer. The number of grain boundaries cutting across each line segment was measured and converted into a crystal width of titanium carbonitride crystals, and the mean crystal widths ($w_3$, $w_4$) were found out by averaging the crystal widths which were respectively figured out at the photographed five points.

Whether the titanium carbonitride layer was single-layered or multilayered was checked in the aforementioned photographs taken with a metallographic microscope or a SEM. When the titanium carbonitride layer was multilayered, the film thicknesses $t_4$, $t_3$ of the upper titanium carbonitride layer and the lower titanium carbonitride layer were measured and the value of the relational expression $t_3/t_4$ was calculated. In a case that a layer boundary was unclear in observing the titanium carbonitride layer, the aforementioned cutting surface was polished so as to be a mirror finished surface, etched with an alkali solution [10%KOH+10%$K_3Fe(CN)_6$] and observed under a metallographic microscope or a SEM to judge whether the titanium carbonitride layer was multilayered or not. The results were presented in Table 5.

Regarding cracks in the hard coating layer of the above-mentioned surface coated cutting tools, depression produced in the Calotest conducted under the conditions below were observed under a metallographic microscope or a SEM. Each crack spacing x, y in the lower structure and upper structure of the titanium carbonitride layer observed in the Calotest depression was measured.

Equipment: CSEM-CALOTEST commercially available from Nanotec Corporation
Steel ball:
Spherical steel ball having a diameter of 30 mm
Diamond paste 1/4MICRON
Cracks were observed in the condition where wear was caused so that the diameter of the substrate exposed in the depression could be 0.1 to 0.6 times (0.3 to 0.7 mm in this measurement) as large as that of the entire depression. As for the above crack spacing, any five straight lines having a length of 200 $\mu$m were respectively drawn in the lower structure and the upper structure, and the crack spacing x, y and the ratio y/x were figured out from the number of intersection points of the straight lines with the cracks.
The results were presented in Table 5.

Fig. 3 (a) is a photograph for observing a Calotest depression of Sample No. IV-2 and Fig. 3 (b) is a photograph for observing a Calotest depression of Sample No. IV-5. In these photographs, a given circle c was drawn in the portion of the titanium carbonitride layer 24 observed at the periphery of the substrate 2 that is a base material. Estimating the number of intersection points p of the circumference of the circle c with the cracks, crack spacing was estimated with the following formula:
Crack spacing = Circumferential length of circle c/Number of intersection points p.
Sample No. IV-2

$$\text{Lower crack spacing: x=1.82 mm} \div \text{4 points=0.4550 mm}$$

Upper crack spacing: y=2.81 mm ÷ 37 points=0.0759 mm

y/x=0.167

Sample No. IV-5

Lower crack spacing: x=1.82 mm ÷ 28 points=0.0650 mm

Upper crack spacing: y=2.99 mm ÷ 41 points=0.0729 mm

y/x=1.122

Regarding all the samples including these samples, the results of calculating crack spacing were presented in Table 5.

Furthermore, the adhesive force of the hard coating layer was measured in the scratch test under the same measurement conditions as Example 1. The results were presented in Table 5.

[Table 5]

| Sample No. | Bottom layer | TiCN layer | | Middle layer | Thickness of Al$_2$O$_3$ layer ($\mu$m) | Cooling rate °C/min. | Crack spacing | | | Adhesive force of Al$_2$O$_3$ layer (N) |
|---|---|---|---|---|---|---|---|---|---|---|
| | | Lower TiCN layer | Upper TiCN layer | | | | x($\mu$m) | y($\mu$m) | y/x | |
| IV-1 | TiN (0.5) | TiCN1<c> (5.0)[0.3] | TiCN2<c> (2.0)[0.6] | TiNO (0.5) | 2.5 | 29 | 111 | 53 | 0.48 | 44 |
| IV-2 | TiN (0.6) | TiCN1<c> (6.0)[0.3] | TiCN4<c> (1.5)[1.0] | TiCNO (0.5) | 2 | 24 | 455 | 76 | 0.17 | 48 |
| IV-3 | TiN (0.7) | TiCN1<c> (4.0)[0.3] | TiCN3<c> (2.0)[0.8] | TiCNO (0.5) | 2.5 | 21 | >500 | 47 | 0 | 41 |
| IV-4 | TiN (0.6) | TiCN1<c> (6.0)[0.3] | TiCN5<c> (4.0)[1.5] | TiCO (0.5) | 3 | 12 | 166 | 100 | 0.60 | 46 |
| * IV-5 | TiN (0.6) | TiCN5<c> (4.0)[0.3] | TiCN5<c> (4.0)[2.0] | TiCNO (0.5) | 3.5 | 8 | 65 | 73 | 1.12 | 20 |
| * IV-6 | TiN (0.4) | TiCN2<c> (6.0)[0.6] | TiCN2<c> (3.0)[0.5] | TiCNO (0.5) | 4 | 32 | 103 | 120 | 1.17 | 33 |
| *IV-7 | TiN (0.4) | TiCNS<c> (8.5)[0.3~1.5] | | TiNO (0.5) | 3 | 22 | 71 | 77 | 1.08 | 42 |

Samples marked '*' are out of the scope of the present invention.
( ) represents layer thickness and [ ] represents a mean crystal width. Unit: $\mu$m
TiCN<c> represents columnar TiCN.
Large crack spacing of over 500 $\mu$m is all shown as ' >500'.

Using the cutting tools, continuous cutting test and interrupted cutting test were conducted under the following conditions to evaluate resistance to wear and fracture.
The results are presented in Table 6.
(Continuous cutting test)
Under the same cutting conditions of the continuous cutting test as in Example 1, changing the feed rate to 0.4 mm/rev, the test was conducted.
(Interrupted cutting test)
Under the same cutting conditions of the interrupted cutting test as in Example 1, changing the cutting speed to 200 m/minute, the test was conducted.

[Table 6]

| Sample No. | Wear resistance test: wear amount (mm) | | Fracture resistance test Number of impacts before fracture (times) | Condition of hard layer |
|---|---|---|---|---|
| | Flank wear | Nose wear | | |
| IV- 1 | 0.14 | 0.12 | 4500 | Nothing abnormal |
| IV- 2 | 0.18 | 0.15 | 5800 | Nothing abnormal |
| IV- 3 | 0.16 | 0.16 | 6000 | Nothing abnormal |
| IV- 4 | 0.18 | 0.20 | 5000 | Nothing abnormal |
| *IV- 5 | 0.32 | 0.29 | 1100 | Minute chipping |
| *IV- 6 | 0.25 | 0.32 | 2500 | Chipping |
| *IV- 7 | 0.24 | 0.21 | 3000 | Minute chipping |
| Samples marked '*' are out of the scope of the present invention. | | | | |

In Tables 4 to 6, Sample No. IV-5 composed of a single-layer titanium carbonitride layer and having cracks uniformly and closely throughout the entire titanium carbonitride layer, had chipping in the hard coating layer of the cutting edge part from the initial stage of cutting and was broken earlier because of the chipping. Moreover, Sample No. IV-6 coated with a titanium carbonitride layer comprising two-layers coated under the same conditions and having microscopic particle size, had a uniform average crack spacing as a whole in the observation of depression of Calotest and also had chipping, resulting in fracture when 2500 pieces were processed. In Sample No. IV-7 having a gradient-structured titanium carbonitride layer, the average crack spacing of the lower structure was narrower than that of the upper structure, the strength of the titanium carbonitride layer was not enough and minute chipping occurred, leading to deterioration in fracture resistance.

In contrast, Samples Nos. IV-1 to IV-4 according to the present invention, having a structure where the average crack spacing of the upper structure (upper titanium carbonitride layer) on the aluminum oxide layer side was narrower than that of the lower structure (lower titanium carbonitride layer) on the substrate side of the titanium carbonitride layer, had no peeling of the hard coating layer, a long life both in continuous cutting and interrupted cutting, and excellent cutting performance in terms of resistance to fracture and chipping. Sample Nos. IV-1 to IV-4 having a multilayer titanium carbonitride layer, especially Sample No. IV-3 where the average crack spacing of the lower titanium carbonitride layer was as wide as not less than 500 $\mu$m, namely, cracks were rarely observed, had the most excellent resistance to wear and fracture.

Brief Description of the Drawings

[Fig. 1] a scanning electron micrograph showing one example of the cutting surface of the surface coated cutting tool according to the first embodiment of the present invention.

[Fig. 2] (a) is a scanning electron micrograph in observing, from the surface, a preferable structure for the fine titanium carbonitride (TiCN) layer of the surface coated member according to the first embodiment of the present invention; and (b) is a scanning electron micrograph in observing, from the surface, the titanium carbonitride (TiCN) layer (a preferable structure as the upper TiCN layer) of the other surface coated member according to this embodiment.
[Fig. 3] (a) is a metallographic microscope image showing a depression in Calotest of the surface coated cutting tool according to the second embodiment of the present invention; (b) is a metallographic microscope image showing a depression in Calotest of the surface coated cutting tool in a comparative example.

[Fig. 4] This is a scanning electron microscope image of the surface coating layer region in the cutting surface of the surface coated cutting tool of Fig. 3 (a).

[Fig. 5] This is a pattern diagram for explaining the method of Calotest.

Description of Reference Numerals

| | |
|---|---|
| 1, 21 | Surface coated cutting tool (tool) |
| 2 | Substrate |
| 3,23 | Hard coating layer |
| 4 | Upper layer (aluminum oxide layer) |
| 5 | Lower layer (titanium carbonitride layer) |
| 5a | Fine titanium carbonitride layer |
| 6 | Titanium carbonitride lower layer |
| 7 | Titanium carbonitride upper layer |
| 8 | Titanium carbonitride particle |
| 8a | Fine titanium carbonitride particle |
| 8b | Titanium carbonitride particle in the titanium carbonitride upper layer |
| 10 | Base layer |
| 11 | Middle layer |
| 12 | Surface layer |
| 24 | Titanium carbonitride layer |
| 25 | Crack |
| 27 | Depression |
| 31 | Lower structure of titanium carbonitride layer |
| 32 | Upper structure of titanium carbonitride layer |
| 33 | Hard ball |
| 34 | Support rod |
| 35 | Lower titanium carbonitride layer |
| 36 | Upper titanium carbonitride layer |
| A | Line indicating the position 0.5 $\mu$m away from the interface between the aluminum oxide layer and the titanium carbonitride layer toward the substrate |
| B | Line indicating the position 1 $\mu$m away from the interface between the substrate and the titanium carbonitride layer toward the aluminum oxide layer |
| $h_1$ | Position of height where the mean crystal width of the titanium carbonitride lower layer is measured |
| $h_2$ | Position of height where the mean crystal width of the titanium carbonitride upper layer is measured |
| $w_1$ | Mean crystal width of the titanium carbonitride lower layer |
| $w_2$ | Mean crystal width of the titanium carbonitride upper layer |
| $t_1$ | Film thickness of the titanium carbonitride lower layer |
| $t_2$ | Film thickness of the titanium carbonitride upper layer |
| c | Circle in measuring average crack spacing |
| p | Intersection point of the circle c with a crack |
| x | Average crack spacing in the lower structure (substrate side) of the titanium carbonitride layer |
| y | Average crack spacing in the upper structure (aluminum oxide layer side) of the titanium carbonitride layer |
| $w_3$ | Mean crystal width on the substrate side of the titanium carbonitride layer |
| $w_4$ | Mean crystal width on the aluminum oxide layer side of the titanium carbonitride layer |
| $t_3$ | Film thickness of the lower structure of the titanium carbonitride layer |
| $t_4$ | Film thickness of the upper structure of the titanium carbonitride layer |

**Claims**

1. A surface coated member, comprising a substrate, a lower layer composed of at least one layer and coated on the surface of the substrate, and an upper layer composed of at least one layer and coated on the surface of the lower layer,

wherein when $F_U$ stands for a peeling load under which the upper layer starts to peel away from the surface of the lower layer and $F_L$ stands for a peeling load under which the lower layer starts to peel away from the surface of the substrate, the ratio ($F_L/F_U$) is 1.1 to 30.

2. The surface coated member according to claim 1, wherein the peeling load ($F_U$) is 10 to 75N and the peeling load ($F_L$) is not less than 80N.

3. The surface coated member according to claim 1, wherein interface roughness R in the interface between the upper layer and the lower layer that is figured out based on the method of arithmetical mean surface roughness (Ra) from irregular shape is 0.5 to 3.0 $\mu$m.

4. The surface coated member according to claim 1, wherein the upper layer has a film thickness of 2.0 to 10.0 $\mu$m and the lower layer has a film thickness of 3.0 to 15.0 $\mu$m.

5. The surface coated member according to claim 1, wherein the upper layer has at least one aluminum oxide layer, and the lower layer has at least one titanium carbonitride layer.

6. The surface coated member according to claim 5, wherein the titanium carbonitride layer is composed of columnar titanium carbonitride crystals which have grown in a direction vertical to the surface of the substrate, and the mean crystal width of the columnar titanium carbonitride crystals on the aluminum oxide layer side is larger than the mean crystal width on the substrate side.

7. The surface coated member according to claim 6, wherein a mean crystal width $w_1$ on the substrate side is 0.05 to 0.7 $\mu$m, and the ratio ($w_1/w_2$) of the mean crystal width $w_1$ on the substrate side to a mean crystal width $w_2$ of the columnar titanium carbonitride crystals on the aluminum oxide layer side is not more than 0.7.

8. The surface coated member according to claim 6, wherein the titanium carbonitride layer is composed at least of a titanium carbonitride upper layer coated on the aluminum oxide layer side and a titanium carbonitride lower layer coated on the substrate side, and the mean crystal width of the titanium carbonitride upper layer is larger than that of the titanium carbonitride lower layer.

9. The surface coated member according to claim 8, wherein the titanium carbonitride lower layer has a film thickness $t_1$ of 1.0 to 10.0 $\mu$m, the titanium carbonitride upper layer has a film thickness $t_2$ of 1.0 to 5.0 $\mu$m, and the relation of $1 < t_1/t_2 \leq 5$ is satisfied.

10. The surface coated member according to claim 8, wherein when the titanium carbonitride lower layer is viewed from the surface direction, the titanium carbonitride lower layer is composed of the aggregate of acicular titanium carbonitride particles, and the acicular titanium carbonitride particles respectively grow in a random direction on the surface of the titanium carbonitride lower layer.

11. The surface coated member according to claim 10, wherein the acicular titanium carbonitride particles have an average aspect ratio of not less than 2 when observed from the surface direction of the titanium carbonitride lower layer.

12. The surface coated member according to claim 10, wherein the acicular titanium carbonitride particles have an average long axis length of not more than 1 $\mu$m when observed from the surface direction of the titanium carbonitride lower layer.

13. The surface coated member according to claim 5, wherein at least one of a surface layer coated on the uppermost surface of the upper layer, a middle layer coated on the bottommost surface of the upper layer and a base layer coated on the surface of the substrate in the lower layer is a coating layer composed of one or more layers selected from the group consisting of TiN layer, TiC layer, TiCNO layer, TiCO layer and TiNO layer.

14. The surface coated member according to claim 5, wherein at least one of the titanium carbonitride layer and the aluminum oxide layer is composed of two or more layers, and one or more layers selected from the group consisting of TiN layer, TiC layer, TiCNO layer, TiCO layer and TiNO layer are coated between the two or more layers.

15. The surface coated member according to claim 5, wherein the aluminum oxide layer has $\alpha$(alpha)-type crystal

structure.

**16.** A surface coated member, comprising a substrate and a hard coating layer, the hard coating layer including a titanium carbonitride layer coated on the surface of the substrate and an aluminum oxide layer coated on the surface of the titanium carbonitride layer,
wherein the titanium carbonitride layer is observed at the periphery of the substrate exposed in a depression having a spherical surface, which is formed in the hard coating layer so as to expose the titanium carbonitride layer of the hard coating layer and the substrate, by rotating a hard ball on the surface of the hard coating layer and partially wearing down the contact point of the hard ball in the hard coating layer; and has a lower structure having no or few cracks, and an upper structure observed at the periphery of the lower structure and having higher density of cracks than the lower structure.

**17.** A surface coated member, comprising a substrate and a hard coating layer, the hard coating layer including at least a titanium carbonitride layer coated on the surface of the substrate and an aluminum oxide layer coated on the surface of the titanium carbonitride layer,
wherein the titanium carbonitride layer is composed of a multilayer including a lower titanium carbonitride layer having no or few cracks, and an upper titanium carbonitride layer observed around the lower titanium carbonitride layer and having higher density of cracks than the lower titanium carbonitride layer, when observing the periphery of the substrate exposed in the depression according to claim 16.

**18.** The surface coated member according to claim 17, wherein the lower titanium carbonitride layer has a film thickness $t_3$ of 1 $\mu$m $\leq t_3 \leq$ 10 $\mu$m, the upper titanium carbonitride layer has a film thickness $t_4$ of 0.5 $\mu$m $\leq t_4 \leq$ 5 $\mu$m, and the relation of $1 < t_3/t_4 \leq 5$ is satisfied.

**19.** The surface coated member according to claim 17, wherein titanium carbonitride particles in the lower titanium carbonitride layer and the upper titanium carbonitride layer grow vertically to the surface of the substrate and have a columnar structure, and the mean crystal width of the titanium carbonitride particles constituting the upper titanium carbonitride layer is larger than that of the titanium carbonitride particles constituting the lower titanium carbonitride layer.

**20.** The surface coated member according to claim 19, wherein the upper titanium carbonitride layer has a mean crystal width $w_4$ of 0.2 to 1.5 $\mu$m and the ratio ($w_3/w_4$) of a mean crystal width $w_3$ in the lower titanium carbonitride layer to the mean crystal width $w_4$ of the upper titanium carbonitride layer is not more than 0.7.

**21.** The surface coated member according to claim 17, wherein the lower titanium carbonitride layer and the upper titanium carbonitride layer are represented as Ti ($C_{1-m}N_m$), and the lower titanium carbonitride layer meets the condition of m=0.55 to 0.80 and the upper titanium carbonitride layer meets the condition of m=0.40 to 0.55.

**22.** A cutting tool for performing cutting by putting on a workpiece material a cutting edge that is formed on the cross ridge portion of a rake face and a flank face, wherein the cutting edge comprises the surface coated member according to claim 1.

**23.** A cutting tool comprising a substrate, a titanium carbonitride layer coated on the surface of the substrate and an aluminum oxide layer coated on the surface of the titanium carbonitride layer,
wherein when $F_U$ stands for a peeling load under which the aluminum oxide layer starts to peel away from the surface of the titanium carbonitride layer and $F_L$ stands for a peeling load under which the titanium carbonitride layer starts to peel away from the surface of the substrate, the peeling load $F_U$ is 10 to 75N, the peeling load $F_L$ is not less than 80N, and the ratio ($F_L/F_U$) is 1.1 to 30.

**24.** A cutting tool for performing cutting by putting on a workpiece material a cutting edge that is formed on the cross ridge portion of a rake face and a flank face, wherein the cutting edge comprises the surface coated member according to claim 16 or claim 17.

[FIG. 1]

[FIG. 2]

(a)

(b)

[FIG. 3]

(a)

(b)

[FIG. 4]

[FIG. 5]

## INTERNATIONAL SEARCH REPORT

| International application No. |
|---|
| PCT/JP2005/005966 |

A. CLASSIFICATION OF SUBJECT MATTER
    Int.Cl$^7$  B32B9/00, B23B27/14, 51/00, B23C5/16, C23C16/32, 28/04

According to International Patent Classification (IPC) or to both national classification and IPC

B. FIELDS SEARCHED

Minimum documentation searched (classification system followed by classification symbols)
    Int.Cl$^7$  B32B9/00, B23B27/14, 51/00, B23C5/16, C23C16/32, 28/04

Documentation searched other than minimum documentation to the extent that such documents are included in the fields searched
    Jitsuyo Shinan Koho          1922-1996   Jitsuyo Shinan Toroku Koho   1996-2005
    Kokai Jitsuyo Shinan Koho    1971-2005   Toroku Jitsuyo Shinan Koho   1994-2005

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2001-341007 A  (Sumitomo Electric Industries, Ltd.), | 1-5,13-15, 22-23 |
| A | 11 December, 2001 (11.12.01), Claims; Par. Nos. [0003] to [0005] (Family: none) | 6-12,16-21, 24 |
| X | JP 11-335870 A  (Hitachi Metals, Ltd.), 07 December, 1999 (07.12.99), | 1-5,13-15, 22-23 |
| A | Claims; Par. Nos. [0003], [0009], [0016] (Family: none) | 6-12,16-21, 24 |
| A | JP 7-328810 A  (Mitsubishi Materials Corp.), 19 December, 1995 (19.12.95), Claims & EP 685572 A2          & US 5920760 A | 1-24 |

| [X] Further documents are listed in the continuation of Box C. | | [ ] See patent family annex. |
|---|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 07 July, 2005 (07.07.05) | 26 July, 2005 (26.07.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

International application No.

PCT/JP2005/005966

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2001-277006 A (Sumitomo Electric Industries, Ltd.), 09 October, 2001 (09.10.01), Claims (Family: none) | 1-24 |

Form PCT/ISA/210 (continuation of second sheet) (January 2004)

## INTERNATIONAL SEARCH REPORT

International application No.

PCT/JP2005/005966

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically: Claims

3. ☐ Claims Nos.:
because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:
    The inventions of Claims 1-5, 13-15, 22-23 are such that the ratio of the peel load at which the upper layer starts to peel off the surface of the lower layer to the peel load at which the lower layer starts to peel off the surface of the base body is in a definite range.
    The inventions of Claims 6-12 have a layer consisting of streaky titanium carbonitride crystals grown in a direction normal to the surface of the base body, and an aluminum oxide layer formed on the first-mentioned layer, the average crystal width on the aluminum oxide side of the titanium carbonitride crystals being greater than that on the base body side.
    (continued to extra sheet.)

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**
☐ The additional search fees were accompanied by the applicant's protest.
☐ No protest accompanied the payment of additional search fees.

Form PCT/ISA/210 (continuation of first sheet (2)) (January 2004)

| INTERNATIONAL SEARCH REPORT | International application No. |
|---|---|
| | PCT/JP2005/005966 |

<u>Continuation of Box No.III of continuation of first sheet(2)</u>

Further, the inventions of Claims 16-21 have a titanium carbonitride layer on the base body, and an aluminum oxide layer thereon, wherein hard balls are rotated for rolling on the aluminum oxide layer to locally wear the latter to enable the titanium carbonitride layer to be observed in outer peripheral positions on the base body through the traces of wear; in such titanium carbonitride layer, there are a lower structure with cracks absent or sparsely present, and an upper structure with cracks densely present.

As for the inventions of Claims 1-5, 13-24, no search has been made except for the matters that are concretely disclosed as embodiments in the detailed description of the invention, for the following reasons.

The inventions of Claims 1-5, 13-15, 22-23 specify an invention of product by defining the relation between the peel strength between specific layers and the peel strength between other specific layers. However, it is not clear what product except the embodiments concretely described in the detailed description of the invention falls within the scope of the inventions as claimed in Claims 1-5, 13-15, 22, 23. Therefore, the inventions are obscure.

The inventions of Claims 1-5, 13-15, 22-23 include a wide range of coating members by specifying an invention of product by said parameter definition. However, described in the detailed description of the invention are only some concrete examples in which the results of measurement of what has been obtained just fall within said defined range. Therefore, the inventions of Claims 1-5, 13-15, 22-23 are notfully supported by the detailed description of the invention.

The inventions of Claims 16-21 and 24 specify an invention of product by defining a structure state observed after a special treatment has been given. However, a concrete product having a structure which brings about such special results cannot be through of. Thus, the inventions are obscure.

The inventions of Claims 16-21 and 24 include a wide range of coating members by specifying an invention of product by said special definition. However, described in the detailed description of the invention are only some concrete examples in which the results of measurement of what has been obtained just fall within said defined range. Therefore, the inventions of Claims 16-21 and 24 are not fully supported by the detailed description of the invention.

Form PCT/ISA/210 (extra sheet) (January 2004)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8001408 A
- JP 5169302 A
- JP 2002212707 A